(19) Europäisches Patentamt / European Patent Office / Office européen des brevets

(11) **EP 2 960 219 B1**

(12) **EUROPÄISCHE PATENTSCHRIFT**

(45) Veröffentlichungstag und Bekanntmachung des Hinweises auf die Patenterteilung:
**16.01.2019 Patentblatt 2019/03**

(51) Int Cl.:
*C03C 3/06* (2006.01)   *C03B 19/14* (2006.01)
*G03F 1/24* (2012.01)

(21) Anmeldenummer: **14174699.0**

(22) Anmeldetag: **27.06.2014**

(54) **Rohling aus Titan-dotiertem Kieselglas für ein Spiegelsubstrat für den Einsatz in der EUV-Lithographie und Verfahren für seine Herstellung**

Blank made of titanium- doped silica glass for a mirror substrate for use in EUV lithography and method for its preparation

Ebauche en verre de quartz doté de titane pour un substrat de miroir à utiliser dans la lithographie EUV et son procédé de fabrication

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**30.12.2015 Patentblatt 2015/53**

(73) Patentinhaber: **Heraeus Quarzglas GmbH & Co. KG**
**63450 Hanau (DE)**

(72) Erfinder:
• **Becker, Klaus**
**63452 Hanau (DE)**
• **Ochs, Stefan**
**63571 Gelnhausen (DE)**
• **Thomas, Stephan**
**63538 Großkrotzenburg (DE)**

(74) Vertreter: **Staudt, Armin Walter**
**Sandeldamm 24a**
**63450 Hanau (DE)**

(56) Entgegenhaltungen:
DE-A1- 4 204 406    DE-A1-102004 024 808
DE-A1-102010 009 589    DE-B3-102013 101 328
US-A1- 2010 003 609

## Beschreibung

Technischer Hintergrund

Die vorliegende Erfindung betrifft einen Rohling aus Titan-dotiertem Kieselglas für ein Spiegelsubstrat für den Einsatz in der EUV-Lithographie, mit einem zu verspiegelnden Oberflächenbereich mit einer optisch genutzten Fläche CA, über der der thermische Ausdehnungskoeffizient CTE ein über die Rohling-Dicke gemitteltes, zweidimensionales dCTE-Verteilungsprofil mit einer als Differenz zwischen einem Inhomogenitäts-Maximalwert und einem Inhomogenitäts-Minimalwert definierten, maximalen Inhomogenität $dCTE_{max}$ von weniger als 5 ppb/K aufweist.

Weiterhin betrifft die Erfindung ein Verfahren zur Herstellung eines derartigen Rohlings aus Titan-dotiertem, hochkieselsäurehaltigem Glas (Quarzglas) für ein Spiegelsubstrat für den Einsatz in der EUV-Lithographie.

Stand der Technik

Bei der EUV-Lithographie werden mittels mikrolithographischer Projektionsgeräte hochintegrierte Strukturen mit einer Linienbreite von weniger als 50 nm erzeugt. Dabei wird Arbeitsstrahlung aus dem Spektralbereich zwischen 10 nm und 121 nm eingesetzt, der als EUV-Bereich bezeichnet wird (Extreme Ultraviolet light, auch als "weiche Röntgenstrahlung" bekannt). Die typische Arbeitswellenlänge bei der EUV-Lithographie liegt derzeit bei 13 nm.

Die Projektionsgeräte sind mit Spiegelelementen ausgestattet, die aus synthetischem, hochkieselsäurehaltigem und mit Titandioxid dotiertem Glas (im Folgenden auch als "$TiO_2$-$SiO_2$-Glas"," Ti-dotiertes Kieselglas" bezeichnet) bestehen und die mit einem reflektierenden Schichtsystem versehen sind. Diese Werkstoffe zeichnen sich durch einen extrem niedrigen thermischen Ausdehnungskoeffizienten aus (im Folgenden kurz als "CTE" bezeichnet; coefficient of thermal expansion). Beim CTE handelt es sich um eine Glaseigenschaft, die von der thermischen Historie des Glases und einigen anderen Parametern abhängt, in erster Linie aber von der Titandioxid-Konzentration. Typische Titandioxid-Konzentrationen liegen zwischen 6 und 9 Gew.-%.

Der Rohling aus Ti-dotiertem Kieselglas wird mechanisch zu dem Spiegelsubstrat bearbeitet und zur Bildung eines Spiegelelements verspiegelt. Das Spiegelelement weist eine optisch genutzte Fläche CA auf (CA steht für "Clear Aperture"), die für jedes Spiegelelement spezifiziert ist und auf die beim Einsatz in einem EUV-Projektionssystem ein vorgegebenes Bestrahlungsprofil auftrifft. Auch im unverspiegelten Spiegelelement-Rohling ist CA als Projektion auf die Rohling-Oberfläche bereits definiert, und zwar unabhängig vom Bearbeitungszustand des Rohlings (vor oder nach mechanischer Bearbeitung).

Die maximale (theoretische) Reflektivität eines derartigen EUV-Spiegelelements liegt bei etwa 70%, so dass mindestens 30% der Strahlungsenergie in der Spiegelbeschichtung und im oberflächennahen Bereich des Spiegelsubstrats absorbiert und in Wärme umgesetzt werden. Über das Gesamtvolumen gesehen, ergibt sich daher eine inhomogene Temperaturverteilung mit einer Temperaturdifferenz, die bei typischen Einsatzbedingungen bis zu 50°C betragen und zu einer Deformation des Spiegelsubstrats führen kann.

Um diese gering zu halten, wäre es daher wünschenswert, wenn das Spiegelsubstrat in einem maßgeblichen Volumen einen CTE hat, der im gesamten Arbeitstemperaturbereich um Null liegt. In der Praxis ist diese Bedingung jedoch schwierig zu erfüllen, da für eine gegebene Glaszusammensetzung der Temperaturbereich mit einem CTE um Null schmal ist.

Diejenige Temperatur, bei der CTE genau gleich Null ist, wird auch als Nulldurchgangs-Temperatur oder als $T_{ZC}$ (Temperature of Zero Crossing) bezeichnet. Auch diese Glaseigenschaft hängt im Wesentlichen von der Titan-Konzentration ab. Diese ist typischerweise so eingestellt, dass der CTE im Temperaturbereich zwischen 20 °C und 45 °C um etwa Null liegt.

Um Abbildungsfehler durch inhomogene Temperaturverteilung im Spiegelsubstrat-Rohling zu reduzieren, ist in der WO 2011/078414 A2 vorgesehen, bei einem

Spiegelsubstrat-Rohling die Konzentration an Titanoxid über die Dicke des Rohlings schrittweise oder kontinuierlich an die sich beim Betrieb einstellende Temperaturverteilung so anzupassen, dass an jeder Stelle die Bedingung für die Nulldurchgangs-Temperatur $T_{ZC}$ erfüllt sind, also der thermische Ausdehnungskoeffizient für die sich lokal einstellende Temperatur im Wesentlichen gleich Null ist. Dies soll dadurch erreicht werden, dass bei der Herstellung des Glases durch Flammenhydrolyse die Konzentration an titan- beziehungsweise siliziumhaltiger Ausgangssubstanzen so variiert wird, dass sich ein vorgegebenes Konzentrationsprofil im Rohling einstellt.

Es liegt auf der Hand, dass die reproduzierbare Einstellung einer variablen, ortsabhängigen Titandioxid-Konzentration über das Volumen des Spiegelsubstrat-Rohlings aufwändig ist und auch nur für einen von vielen Spiegeln des Projektionsgerätes und nur eine einzige konkrete Bestrahlungskonstellation optimiert sein kann.

Einen anderen Weg geht die DE 10 2004 024 808 A1, aus der ein Quarzglasrohling für ein Spiegelsubstrat der eingangs genannten Art und ein Verfahren zu seiner Herstellung bekannt sind. Der daraus bekannte Rohling aus Titan-dotiertem, synthetisch erzeugtem Quarzglas ist zylinderförmig ausgebildet, er hat beispielsweise einen Durchmesser von 300 mm und eine Dicke von 40 mm. Durch mechanische Bearbeitung wird daraus eine Spiegelsubstratplatte erhalten, die ganz oder teilweise verspiegelt wird.

Es wird vorgeschlagen, örtliche Homogenitätsschwankungen im thermischen Ausdehnungskoeffizienten (im Folgenden auch als "CTE-Inhomogenität" oder mit der Kurzform "dCTE" bezeichnet und definiert als Betrag der örtlichen Abweichung von einem absoluten Minimalwert $CTE_{min}$ des CTE-Verteilungsprofils: $(dCTE=CTE-CTE_{min})$ zu Gunsten einer kostengünstigeren Herstellungsweise unter bestimmten Bedingungen hinzunehmen. Diese Bedingungen beinhalten, dass die dCTE einen vorgegebenen Grenzwert nicht überschreitet und dass sie bei einer Messung über die optisch genutzte Fläche CA einen Verlauf zeigt, der hinreichend genau durch wenige niedrigfrequente, sphärische Zernike-Polynominale beschreibbar ist. Genauer gesagt, hat der bekannte Quarzglasrohling folgende Eigenschaften:

a) er enthält Mikroinhomogenitäten durch lokale Varianz der $TiO_2$-Verteilung von weniger als 0,05% $TiO_2$,

b) er zeigt eine radiale Varianz des thermischen Ausdehnungskoeffizienten über die nutzbare Fläche CA von maximal 0,4 ppb/(K·cm),

c) seine absolute, maximale Inhomogenität im thermischen Ausdehnungskoeffizienten $dCTE_{max}$ auf der optisch genutzten Fläche CA (gemittelt über die Dicke des Rohlings) beträgt weniger als 5 ppb/K,

d) wobei sich der Verlauf von dCTE über CA im Wesentlichen durch folgende Zernike-Terme beschreiben lässt:

$$dCTE = C_0^\alpha + C_3^\alpha \left( 2 \left( \frac{r}{R} \right)^2 - 1 \right) + C_8^\alpha \left( 6 \left( \frac{r}{R} \right)^4 - 6 \left( \frac{r}{R} \right)^2 + 1 \right) \qquad (1)$$

Dabei gilt: $C_0^\alpha <= 5$ ppb/K; r= radialer Abstand von der Zylinderachse;
R= Radius von CA; C3; C8 = Anpassungsparameter der Terme.

Dabei bedeutet "im Wesentlichen durch Zernike-Terme beschreibbar", dass nach Abzug dieser Terme die verbleibende Restinhomogenität der thermischen Ausdehnung nicht mehr als 0,5 ppb/K beträgt (im Originaldokument ist "dCTE" als "$\Delta\alpha$" bezeichnet).

Die US 2010/0003609 A1 befasst sich mit der Herstellung eines Ti-dotierten Glasrohlings für die EUV-Lithographie, und zwar in erster Linie für Maskenplatten. Es wurde gefunden, dass es einen Zusammenhang zwischen den Verteilungsprofilen von Brechungsindex und Hydroxylgruppengehalt und der Polierbarkeit und damit der erzielbaren Oberflächenqualität des Glasrohlings gibt. Daher wird vorgeschlagen, dass der Glasrohling ein radiales Brechungsindex-Verteilungsprofil haben sollte, bei dem nur ein Maximum vorhanden ist, wobei dieses möglichst in der Mitte des Rohlings liegt. Dies gilt auch dann wenn der Rohling polygonalen Querschnitt hat, wie bei Maskenplatten üblich. Der polygonale Querschnitt wird durch "Ausfließenlassen" eines Rundstabes in eine rechteckige Form erzeugt. Dementsprechend werden nicht-kreisrunde Verteilungsprofile für den Brechungsindex und den Hydroxylgruppengehalt erhalten.

Technische Aufgabenstellung

CTE-Inhomogenitäten, die diese Bedingungen erfüllen, zeigen über CA ein im Wesentlichen rotationssymmetrisches Verteilungsprofil. Ein so angepasster Spiegelsubstrat-Rohling verzeiht vergleichsweise hohe absolute CTE-Inhomogenitätswerte auch bei inhomogener Erwärmung, sofern die im Einsatz auftretenden Bestrahlungsprofile und damit die optisch genutzte Fläche CA Kreissymmetrie haben. Für den Einsatz mit Bestrahlungsprofilen mit einer von der Kreisform abweichende Geometrie ist der bekannte Spiegelsubstrat-Rohling jedoch nicht geeignet.

Es ist Aufgabe der vorliegenden Erfindung, einen Rohling aus Titan-dotiertem Kieselglas für ein Spiegelsubstrat für den Einsatz in der EUV-Lithographie bereitzustellen, der auch ohne individuell angepasste, ortsabhängige Einstellung der Ti tandioxid-Konzentration für den Einsatz mit nicht-kreisrundem Bestrahlungsprofil ausgelegt und geeignet ist.

Weiterhin liegt der Erfindung die Aufgabe zugrunde, ein Verfahren anzugeben, das die reproduzierbare und kostengünstige Herstellung eines derartigen Spiegelsubstrat-Rohlings ermöglicht.

Allgemeine Beschreibung der Erfindung

Hinsichtlich des Spiegelsubstrat-Rohlings wird diese Aufgabe ausgehend von einem Rohling aus Titan-dotiertem Kieselglas der eingangs genannten Gattung erfindungsgemäß dadurch gelöst, dass $dCTE_{max}$ mindestens 0,5 ppb/K beträgt, und dass CA eine nicht-kreisrunde Fläche mit einem Flächenschwerpunkt bildet, wobei das dCTE-Verteilungsprofil nicht rotationssymmetrisch und über CA derart definiert ist, dass gerade und auf eine Einheitslänge normierte Profilschnitte durch den Flächenschwerpunkt eine dCTE-Kurvenschar ergeben, die ein Kurvenband mit einer Bandbreite von weniger als 0,5 x $dCTE_{max}$ bilden.

Neben der Energiedichte der auf das Spiegelelement auftreffenden Strahlung bestimmt auch deren räumliche Verteilung die optische Belastung des Spiegelelements. Die räumliche Verteilung der Strahlung spiegelt sich in erster Näherung in der Geometrie der für jedes Spiegelelement spezifizierten, optisch genutzten Fläche CA wider. Im Gegensatz zur intrinsischen dCTE-Verteilung über der optisch genutzten Fläche CA, stellt diese selbst keine physikalische Eigenschaft des Spiegelelements dar, sondern sie ist Bestandteil der zum Spiegelelement gehörenden Spezifikation.

Örtliche Abweichungen des CTE von einem vorgegebenen Sollwert führen zwangsläufig zu Abbildungsfehlern durch das Spiegelelement, insbesondere durch Erwärmung im Betrieb. Grundsätzlich können derartige Fehler vermindert werden, entweder indem Abweichungen des CTE im Bereich der optisch genutzten Fläche möglichst vollständig vermieden werden, oder indem eine gewisse CTE-Inhomogenität zwar hingenommen, deren örtliche Verteilung jedoch in Bezug auf die optische Belastung optimiert wird.

Die erstgenannte Alternative hat den Vorteil, dass das Spiegelelement mehr oder weniger unabhängig von seiner spezifischen optischen Belastung und der CA-Geometrie gute Qualität und Einsatzfähigkeit zeigen kann. Sie erfordert jedoch hohen Aufwand bei der Herstellung des Ti-dotierten Kieselglases und bei seiner thermisch-mechanischen Nachbearbeitung.

Dies soll die vorliegende Erfindung aber gerade vermeiden. Daher ist ein gewisser Grad an CTE-Inhomogenität im erfindungsgemäßen Spiegelsubstrat-Rohling zugelassen. Dieser zeigt sich darin, dass $dCTE_{max}$ - also die Differenz zwischen dem absoluten CTE-Maximalwert und dem absoluten CTE-Minimalwert des CTE-Verteilungsprofils innerhalb von CA - mindestens 0,5 ppb/K beträgt.

Dadurch ist der Fertigungsaufwand für das Spiegelelement geringer, jedoch ist eine Anpassung des dCTE-Verteilungsprofils an die optische Belastung und dabei insbesondere an Größe und Geometrie von CA erforderlich. Bei einer von der Kreisform abweichenden Geometrie von CA erfolgte diese Anpassung bisher rein empirisch. Eine systematische Methode zur Generierung grundsätzlich geeigneter Anpassungen an die optische Belastung ist für diese Fälle nicht bekannt. Daher war es schwierig, bei Vorgabe spezifischer Anforderungen und Randbedingungen bezüglich der CA den dazu passenden Spiegelsubstrat-Rohling ohne empirische Maßnahmen bereitzustellen. Empirische Methoden genügen jedoch nicht den Anforderungen an eine einfache und kostengünstige industrielle Fertigung.

Die Erfindung stellt nun ein allgemeines Konstruktionsprinzip zur Ausbildung des dCTE-Verteilungsprofils für einen Spiegelsubstrat-Rohling zur Verfügung, wenn die für ihn spezifizierte CA eine von der kreisrunden Form abweichende Geometrie hat.

Allgemeines Konstruktionsprinzip

Ein Aspekt dieses Konstruktionsprinzips betrifft die geometrische Ausgestaltung des dCTE-Verteilungsprofils - es ist nicht rotationssymmetrisch, sondern länglich oval - und ein weiterer Aspekt betrifft das Zusammenspiel zwischen dem länglichovalen dCTE-Verteilungsprofil und der optisch beanspruchten Fläche CA mit nicht-kreisrunder Umrisslinie.

Die Umrisslinie der von der Kreisrundform abweichenden optisch beanspruchten Fläche CA bildet eine geschlossene, in der Regel konvexe Kurve. Die folgenden Erläuterungen der von der Kurve umschlossenen Fläche beziehen sich auf das Beispiel eines "Ovals", gelten aber gleichermaßen auch für nicht-ovale Geometrien, wie in Rechteckform mit abgerundeten Kanten oder in Bohnen- oder Hundeknochenform. Das Oval hat eine Längsausdehnung, die größer ist als seine maximale Breitenausdehnung senkrecht dazu und keine, eine oder zwei Symmetrieachsen. Der Flächenschwerpunkt der ovalen CA wird anhand bekannter geometrischer Überlegungen erhalten oder er wird mathematisch durch Integration berechnet.

Ein Aspekt des allgemeinen Konstruktionsprinzips betrifft das Zusammenspiel zwischen der ovalen Form von CA und dem dCTE-Verteilungsprofil. Dieses Zusammenspiel zeigt sich darin, dass das dCTE-Verteilungsprofil über CA so ausgelegt wird, dass alle geraden Schnitte durch das Verteilungsprofil, die durch den Flächenschwerpunkt von CA verlaufen, einen ähnlichen Verlauf haben. Da sich Längsausdehnung und Breitenausdehnung von CA (und damit auch Längsausdehnung und Breitenausdehnung des dCTE-Verteilungsprofils und der entsprechenden Profilschnitte) unterscheiden, kann die Ähnlichkeit der Verläufe unterschiedlicher Schnitte nur bei einer Normierung auf gleiche Länge festgestellt werden, beispielsweise durch Normierung auf die Länge des längsten Profilschnitts durch den Flächenschwerpunkt. Die entsprechend normierten Profilschnitte werden im Folgenden auch als "längennormierte Profilschnitte" bezeichnet.

Die Verlaufsähnlichkeit zeigt sich unter dieser Voraussetzung darin, dass beliebige längennormierte Profilschnitte eine dCTE-Kurvenschar ergeben, die ein Kurvenband mit einer maximalen Bandbreite von weniger als 0,5 x $dCTE_{max}$, vorzugsweise von weniger als 0,3 x $dCTE_{max}$, bilden. Die "maximale Bandbreite" ergibt sich als maximaler Unterschied zwischen einem Höchstwert und einem Niedrigstwert der dCTE-Werte an allen normierten Profilpositionen entlang des Kurvenbandes.

Die geringe maximale Bandbreite des Kurvenbandes ist ein Maß für die Ähnlichkeit der längennormierten Schnitte durch das dCTE-Verteilungsprofil, und zwar unabhängig vom Schnittwinkel, was an und für sich typisch für ein rotationssymmetrisches dCTE-Verteilungsprofil ist. Ein rotationssymmetrisches Verteilungsprofil ist aber nicht an die hier vorliegende ovale Form von CA angepasst und zur Lösung des technischen Problems ungeeignet.

Das hohe Maß an Ähnlichkeit der längennormierten Schnitte bei dem nichtrotationssymmetrischen dCTE-Verteilungsprofil gemäß der Erfindung beruht darauf, dass es so ausgelegt ist, dass es auf ein im Wesentlichen rotationssymmetrisches dCTE-Verteilungsprofil zurückgeführt werden kann, und zwar durch Streckung eines rotationssymmetrischen Profils in mindestens eine Richtung. Die Richtung der Streckung ist dabei im einfachsten Fall und vorzugsweise so ausgelegt, dass sie senkrecht zur Rotationssymmetrieachse verläuft. Diese Art der Verformung wird im Folgenden auch als "laterale Verformung" bezeichnet.

Das Konstruktionsprinzip beruht daher auf einer geometrischen Transformation, bei der aus einem rotationssymmetrischen dCTE-Verteilungsprofil mit im Wesentlichen kreisrunder Form durch laterale Verformung ein geometrisch ähnliches dCTE-Verteilungsprofil mit nicht-kreisrunder Form erzeugt wird. Durch laterale Verformung wird das dCTE-Verteilungsprofil gegenüber der rotationssymmetrischen dCTE-Verteilung nicht grundlegend und unvorhersehbar, sondern mathematisch weitgehend reproduzierbar und definiert verändert. Dies gilt auch in umgekehrter Richtung der mathematischen Rückführung des nichtrotationssymmetrischen Verteilungsprofils in ein rotationssymmetrisches Verteilungsprofil.

Die dCTE-Verteilungsprofile vor und nach der lateralen Verformung sind in gewisser Weise "ähnlich" zueinander. Die "Ähnlichkeit" der Profile besteht darin, dass sich wesentliche Merkmale einer ursprünglichen rotationssymmetrischen Verteilung in der durch laterale Verformung erhaltenen Verteilung wiederfinden. Zu diesen Merkmalen gehören die Anzahl der relativen und absoluten Extremwerte der Verteilung als auch deren relative Lage zueinander.

So ist beispielsweise ein rotationssymmetrisches dCTE-Verteilungsprofil, wie es in der DE 10 2004 024 808 A1 erläutert und anhand obiger Formel (1) mathematisch beschrieben ist, in Bezug auf eine optische Belastung mit kreisförmiger CA ausgelegt. Dieses Profil - anhand des beschriebenen Konstruktionsprinzips der geometrischen Transformation durch laterale Verformung in ein anderes, nichtrotationssymmetrisches Verteilungsprofil überführt - ist bereits ohne weitere Maßnahme für eine optische Belastung mit länglich-ovaler CA deutlich besser geeignet als ohne diesen Verformungsvorgang.

Das dCTE-Verteilungsprofil hat somit eine nicht-rotationssymmetrische, nicht-kreisrunde Form, die im Idealfall mathematisch eineindeutig durch Strecken eines rotationssymmetrischen Verteilungsprofils in mindestens eine Richtung beschreibbar ist. Der Streckfaktor ist größer 1 oder kleiner 1.

Als nicht-kreisrund wird dabei eine optisch genutzte Fläche CA definiert, bei der die längste Schnittlinie $S_{max}$ durch den Flächenschwerpunkt von CA um mindestens 20 % länger ist als die kürzeste Schnittlinie $S_{min}$ durch den Flächenschwerpunkt ($S_{max}>1{,}2 \times S_{min}$). Als nicht-rotationssymmetrisches dCTE-Verteilungsprofil wird ein Verteilungsprofil definiert, bei dem die Anpassung an die nicht-kreisrunde CA derart ist, dass die oben erläuterte Bedingung bezüglich der "Ähnlichkeit" der Profile infolge enger Bandbreite des Schnittlinien-Kurvenbandes erfüllt ist.

Das Konstruktionsprinzip der geometrischen Transformation der CTE-Inhomogenitäts-Verteilung in Rundform durch laterale Verformung ist auch zur Anpassung an CA-Flächen mit komplexerer Umrisslinie geeignet. Wichtig ist, dass das dabei erzeugte Verteilungsprofil beschreibbar ist durch gleichzeitiges oder sequentielles Strecken des Verteilungsprofils der Rundform (oder von Teilen davon) in mehrere Raumrichtungen. Diese Raumrichtungen verlaufen dabei bevorzugt in einer gemeinsamen Verformungsebene, die sich wiederum vorzugsweise senkrecht zur Ebene der optisch genutzten Fläche CA erstreckt.

Die Anforderung an die Ähnlichkeit der längennormierten Schnitte bei dem nichtrotationssymmetrischen dCTE-Verteilungsprofil gemäß der Erfindung ist über die gesamte ovale, optisch beanspruchte Fläche CA zu erfüllen. Schwierigkeiten treten dabei häufig am Rand von CA auf. Im Folgenden werden zwei bevorzugte Ausführungsformen des erfindungsgemäßen Rohlings beschrieben, die das oben erläuterte, allgemeine Konstruktionsprinzip insbesondere für den Randbereich von CA unter dem Aspekt des Zusammenspiels von CA und dCTE-Verteilungsprofil verfeinern.

Erste Verfeinerung

Das nicht-rotationssymmetrische dCTE-Verteilungsprofil gemäß der Erfindung zeichnet sich dadurch aus, dass es eine nicht-rotationssymmetrische Form hat, innerhalb der geschlossene Isolinien um eine Flächennormale der CA-Ebene verlaufen und die gleiches Niveau der CTE-Inhomogenität repräsentieren, vergleichbar mit Höhenlinien um einen Berggipfel.

Basierend auf dieser Grundbedingung ist bei einer ersten bevorzugten Ausführungsform vorgesehen, dass das dCTE-Verteilungsprofil eine geschlossene Isolinie mit einem dCTE-Wert von $0{,}5 \times dCTE_{max}$ aufweist, von der eine Teillänge von mindestens 80% der Isolinien-Gesamtlänge innerhalb der optisch genutzten Fläche CA verläuft.

Diejenige Isolinie des dCTE-Verteilungsprofil, die einen dCTE-Wert mit halbem Niveau der maximalen dCTE-Inhomogenität repräsentiert, verläuft zu mindestens 80% ihrer Gesamtlänge - vorzugsweise vollständig - innerhalb von CA des Spiegelsubstrat-Rohlings. Bei einem komplexen Verlauf des dCTE-Verteilungsprofils (beispielsweise bei einem Profil mit Wellenform können auch mehrere geschlossene Isolinien auf diesem Niveau verlaufen, die unterschiedlichen Abstand zum Flächenschwerpunkt von CA haben. In diesem Fall ist es in der Regel hilfreich, wenn die Isolinie die am nächsten zur CA-Umrisslinie verläuft, die oben genannte Bedingung erfüllt - also zu 80 % oder mehr ihrer Länge auf oder innerhalb der Umrisslinie von CA verläuft. Idealerweise ist dies auch die Isolinie mit dem größten Abstand zum Flächenschwerpunkt von CA. In anderen Fällen, bei denen nicht eindeutig feststellbar ist, welche Isolinie mit dem Niveau $0,5 \times dCTE_{max}$ näher an CA verläuft oder bei denen es eine solche Isolinie nicht gibt, ist dieses Kriterium zur Einstellung und Beurteilung der Anpassungsgüte des dCTE-Verteilungsprofils an CA nicht anwendbar.

Das bedeutet, dass die Form des dCTE-Inhomogenitäts-Profils der Umrisslinie von CA insoweit angepasst ist, dass die Mehrheit der äquidistanten Isolinien innerhalb von CA verlaufen (zumindest mit 80 % der jeweiligen Isolinienlänge). Im Idealfall ist die Form des dCTE-Inhomogenitäts-Profils der Umrisslinie von CA exakt angepasst, so dass alle Isolinien auf oder innerhalb der Umrisslinie von CA verlaufen.

Zweite Verfeinerung

Bei einer zweiten bevorzugten Ausführungsform des erfindungsgemäßen Rohlings ist vorgesehen, dass die nicht kreisrunde Fläche von CA durch eine nicht-kreisrunde Umrisslinie definiert ist, entlang der ein dCTE-Höchstwert und ein dCTE-Niedrigstwert des dCTE-Verteilungsprofils liegen, wobei der Differenzbetrag - $PV_{CA}$ - zwischen Höchst- und Niedrigstwert maximal $0,5 \times dCTE_{max}$ beträgt.

Während bei der ersten verfeinerten Ausführungsform eine weitgehende Angleichung der geometrischen Formen von nicht-kreisrunder, ovaler CA-Umrisslinie und nicht-rotations-symmetrischem dCTE-Verteilungsprofil im Vordergrund steht, liegt bei der zweiten Verfeinerung das Augenmerk auf einer Quantifizierung der Interaktion zwischen dem dCTE-Verteilungsprofil und der optisch genutzten Fläche CA.

Dabei ist das dCTE-Verteilungsprofil so ausgelegt, dass die CA-Umrisslinie von möglichst wenigen Isolinien des Verteilungsprofils geschnitten wird. Denn je stärker die CA-Umrisslinie von Isolinien geschnitten wird, umso ausgeprägter ist die optische Einwirkung der dCTE-Verteilung auf die Abbildungsgüte innerhalb von CA.

Ein Maß für diese Einwirkung ergibt sich durch Aufsummieren der betragsmäßigen Niveau-Unterschiede der dCTE-Werte entlang der CA-Umrisslinie. Je größer der durch Aufsummieren erhaltene Gesamt-Niveau-Unterschied ist, umso stärker ist der Einfluss des dCTE-Verteilungsprofils auf die optische Abbildung innerhalb von CA. Der Gesamt-Niveau-Unterschied kann jedoch von der Umfangslänge der CA-Umrisslinie abhängen. Daher wird gemäß der Erfindung als Maß für den Grad der Interaktion durch Schneiden der CA-Umrisslinie durch Isolinien des dCTE-Verteilungsprofils der Differenzbetrag $PV_{CA}$ herangezogen, der sich als Differenz aus den dCTE-Extremwerten (Höchstwert und Niedrigstwert) ergibt, die entlang der CA-Umrisslinie auftreten. $PV_{CA}$ beträgt maximal die Hälfte der maximalen dCTE-Inhomogenität über CA insgesamt, vorzugsweise maximal $0,3 \times dCTE_{max}$.

Es hat sich als günstig erwiesen, wenn das Verteilungsprofil durch Strecken eines rotationssymmetrischen Verteilungsprofils in mindestens einer Raumrichtungen mathematisch eineindeutig beschreibbar ist, wobei der Streckfaktor mindestens 1,2 beträgt.

Unter dem Streckfaktor wird dabei das Längenverhältnis nach und vor der Streckung verstanden. Je größer dessen Abweichung von 1 ist, umso stärker macht sich der Vorteil des Verteilungsprofils beim Einsatz des erfindungsgemäßen Rohlings bemerkbar.

Im Hinblick darauf hat es sich auch bewährt, wenn das Verteilungsprofil durch Strecken einer Rundform in mehreren Raumrichtungen, mathematisch eineindeutig beschreibbar ist, wobei diese Raumrichtungen in einer gemeinsamen Verformungsebene verlaufen, die sich parallel zur optisch genutzten Fläche CA erstreckt.

Bei einer vorteilhaften Ausführungsform des erfindungsgemäßen Rohlings ist das dCTE-Verteilungsprofil durch Strecken der Rundform in drei in derselben Verformungsebene verlaufenden Richtungen, die einen Winkel von 120 Grad einschließen, beschreibbar.

Hierbei wird ausgehend vom Mittelpunkt einer rotationsachssymmetrischen Verteilung durch dreifache, gleichzeitige Streckung ein dCTE-Verteilungsprofil erhalten, das beispielsweise die Querschnittsform eines dreiseitigen Kleeblatts, eines Wankelmotor-Kolbens oder eines Plektrons hat.

Hinsichtlich des Herstellungsverfahrens wird die oben genannte technische Aufgabe erfindungsgemäß durch ein Verfahren gelöst, das folgende Verfahrensschritts umfasst:

(a) Bereitstellen eines Glaszylinders aus Ti-dotiertem Kieselglas mit rotationssymmetrischem dCTE-Verteilungsprofil, umfassend:

(aa) Erzeugen eines porösen Sootkörpers aus SiO2 und TiO2 durch Flammenhydrolyse von Silizium und Titan enthaltenden Ausgangssubstanzen,

(bb) Trocknen und Sintern des Sootkörpers unter Bildung eines länglichen Glasvorprodukts aus Ti-dotiertem Kieselglas,

(cc) Homogenisieren des Glasvorprodukts in einem Homogenisierungsprozess, bei dem das Vorprodukt auf eine Temperatur von mehr als 1.500 °C erhitzt, dabei erweicht und zu dem Glaszylinder umgeformt wird, und

(b) Umformen des Glaszylinders, indem dieser erweicht und unter Einwirkung einer Umformkraft, die eine senkrecht zur Glaszylinder-Längsachse wirkende Kraftkomponente hat infolge geometrischer Transformation in eine senkrecht zur Glaszylinder-Längsachse verlaufenden Richtung zu einem zylinderförmigen Rohling geformt wird, der einen nicht-kreisrunden Querschnitt und ein nicht-rotationssymmetrische dCTE-Verteilungsprofil hat.

Ausgangspunkt des erfindungsgemäßen Verfahrens ist ein Glaszylinder mit einem dCTE-Verteilungsprofil, das im Idealfall exakt rotationssymmetrisch zur Zylinderachse verläuft. In der Praxis ist beispielsweise ein zweidimensionales dCTE-Verteilungsprofil ausreichend, das die Anforderungen erfüllt, wie sie in der DE 10 2004 024 808 A1 erläutert und anhand obiger Formal (1) mathematisch umschrieben sind. Ein derartiges Profil wird hier als rotationssymmetrisch definiert, auch wenn es diese Geometrie nicht ganz exakt aufweist.

Zur Anpassung eines derartigen Glaszylinders für den Einsatz mit optischer Belastung mit von der Kreisform abweichender CA wird der Glaszylinder einem Umformprozess unterzogen und dabei anhand der oben erläuterten "geometrischen Transformation" lateral zur Glaszylinder-Längsachse verformt, also gestreckt. Ergebnis des Umformprozesses ist ein zylinderförmiger Rohling aus Ti-dotiertem Kieselglas mit nicht-kreisrundem Querschnitt. Bereits ein einfacher Streckvorgang genügt, um das voreingestellte rotationssymmetrische Profil in ein nicht-rotationssymmetrisches Verteilungsprofil der CTE-Inhomogenität zu überführen, welches auch ohne weitere Anpassungsmaßnahme für eine optische Belastung mit länglich-ovaler CA besser geeignet ist als ohne diesen Umformungsprozess.

Beim Umformen des Glaszylinders gemäß Verfahrensschritt (b) wird dieser einfach oder mehrfach in eine Richtung gestreckt, die senkrecht zur Glaszylinder-Längsachse verläuft. Im Fall einer mehrfachen Umformung können die Verformungsmaßnahmen gleichzeitig oder hintereinander ausgeführt werden. Im zuletzt genannten Fall wird der nach einem Umformschritt erhaltene Glaskörper in einem nachfolgenden Umformschritt weiter verformt.

Dabei entspricht die Glaszylinder-Längsachse der optischen Achse oder der Hauptfunktionsrichtung des zu erzeugenden Spiegelsubstrat-Rohlings. Dadurch wird gewährleistet, dass sich das rotationssymmetrische dCTE-Verteilungsprofil im Glaszylinder in geometrisch ähnlicher Form im umgeformten Rohling wiederfindet. Im Idealfall wirken dabei nur Umformkräfte in Richtung senkrecht zur Glaszylinder-Längsachse; in der Praxis sind jedoch Umformkräfte mit anderen Richtungskomponenten kaum zu vermeiden. Entscheidend für die Qualität und Einsatzfähigkeit des erhaltenen Rohlings ist, dass die "Ähnlichkeit" zum rotationssymmetrischen dCTE-Verteilungsprofil bestehen bleibt. Dieses Ziel wird erreicht, wenn sich die wesentlichen Merkmale der ursprünglichen rotationssymmetrischen Verteilung in der durch Umformung erhaltenen Verteilung wiederfinden. Die wesentlichen Merkmale in diesem Sinne sind die Anzahl der relativen und absoluten Extremwerte der ursprünglichen Verteilung und deren relative Lage zueinander.

Das so eingestellte dCTE-Verteilungsprofil ist nicht rotationssymmetrisch zur Längsachse des ehemaligen Glaszylinders und zeichnet sich dadurch aus,

(1) dass beliebige längennormierte, gerade Profilschnitte, die durch den Flächenschwerpunkt der CA-Fläche gehen, eine dCTE-Kurvenschar ergeben, die ein Kurvenband mit einer maximalen Bandbreite von weniger als 0,5 x dC-TE$_{max}$, vorzugsweise von weniger als 0,3 x dCTE$_{max}$, bilden,

(2) und vorzugsweise, dass um die Längsachse geschlossene Isolinien mit einen Niveau der CTE-Inhomogenität von 0,5 x dCTE$_{max}$ vollständig oder zumindest zu 80% ihrer Länge innerhalb von CA verlaufen,

(3) und/oder vorzugsweise, dass entlang der Umrisslinie von CA der Differenzbetrag - PV$_{CA}$ - zwischen Höchst- und Niedrigstwert maximal 0,5 x dCTE$_{max}$ beträgt,

wie oben anhand des erfindungsgemäßen Rohlings näher erläutert.

Der so erhaltene Formkörper aus TiO$_2$-SiO$_2$-Glas ist entweder nach thermischer Weiterbehandlung, beispielsweise durch Tempern, und/oder mechanischer Weiterverarbeitung, wie Schleifen und Polieren, unmittelbar als Spiegelsubstrat-Rohling einsetzbar oder er dient als Vorprodukt zur Weiterverarbeitung zu dem Rohling.

Das Umformen kann dadurch erfolgen, dass der Glaszylinder mit einer Flamme erwärmt und erweicht und dabei mittels Umformkräften, die an der Zylindermantelfläche angreifen, verformt wird. Insbesondere im Hinblick auf die eine besonders reproduzierbare und definierte Einstellung des CTE-Verteilungsprofils wird jedoch eine Verfahrensweise bevorzugt, bei der das Umformen gemäß Verfahrensschritt (b) einen Umformschritt umfasst, bei dem der Glaszylinder mit vertikal orientierter Glaszylinder-Längsachse in einer Schmelzform mit nicht-rotationssymmetrischer Innengeometrie angeordnet und darin auf eine Temperatur von mindestens 1.200 °C erhitzt und dabei so erweicht wird, dass er unter Einwirkung der Schwerkraft, vorzugsweise unterstützt durch eine Presskraft, in die Schmelzform seitlich ausfließt.

Zur Erzeugung eines dCTE-Verteilungsprofils mit oval-elliptischem Querschnitt genügt es, eine Schmelzform einzusetzen, deren Innengeometrie im Querschnitt in Richtung senkrecht zur Glaszylinder-Längsachse gesehen eine lange Achse und eine demgegenüber kürzere Achse aufweist.

Bei einer bevorzugten Verfahrensweise wird ein dCTE-Verteilungsprofil mit oval-elliptischem Querschnitt beispielsweise dadurch erreicht, dass eine Schmelzform mit einer im Querschnitt ovalen Innengeometrie oder mit einer rechteckigen Innengeometrie eingesetzt wird.

Bei der Herstellung des Ti-dotierten Kieselglases umfasst das Bereitstellen des Glaszylinders gemäß Verfahrensschritt (a):

(aa) Erzeugen eines porösen Sootkörpers aus $SiO_2$ und $TiO_2$ durch Flammenhydrolyse von Silizium und Titan enthaltenden Ausgangssubstanzen

(bb) Trocknen und Sintern des Sootkörpers unter Bildung eines länglichen Glasvorprodukts aus Ti-dotiertem Kieselglas,

(cc) Homogenisieren des Glasvorprodukts in einem Homogenisierungsprozess, bei dem das Vorprodukt auf eine Temperatur von mehr als 1.500 °C erhitzt, dabei erweicht und zu dem Glaszylinder umgeformt wird.

Das Ti-dotierte Kieselglas wird dabei nach dem sogenannten "Sootverfahren" synthetisiert. Dabei wird als Zwischenprodukt ein poröser Sootkörper erhalten, dessen chemische Zusammensetzung durch eine Dotierbehandlung oder durch Trocknung verändert werden kann.

Das Trocknen zur Einstellung eines vorgegebenen Hydroxylgruppengehalts des $TiO_2$-$SiO_2$-Glases erfolgt durch reaktive chemische Behandlung mittels Halogenen oder durch thermische Behandlung des Sootkörpers unter Vakuum.

Durch das Verglasen und das anschließende Homogenisieren wird das $TiO_2$-$SiO_2$-Glas auf eine Temperatur erhitzt, die so hoch ist, dass etwaige Rutil-Mikrokristalle aufschmelzen. Gleichzeitig wird das Glas verformt - beispielsweise durch Verdrillen - um eine homogenere Verteilung der $TiO_2$-Konzentration zu bewirken. Zu diesem Zweck wird das $TiO_2$-$SiO_2$-Glas einem Homogenisierungsprozess unterzogen, bei dem es auf eine Temperatur von mehr als 1.500 °C erhitzt und dabei erweicht und umgeformt wird. Nach Abschluss der Homogenisierung liegt das $TiO_2$-$SiO_2$-Glas in Form des Glaszylinders mit rotationssymmetrischem dCTE-Verteilungsprofil vor.

Ausführungsbeispiel

Nachfolgend wird die Erfindung anhand von Ausführungsbeispielen und einer Zeichnung näher erläutert. Im Einzelnen zeigt:

| | |
|---|---|
| **Figur 1** | ein dCTE-Verteilungsprofil eines $SiO_2$-$TiO_2$-Rohlings mit rundem Querschnitt in Falschfarbendarstellung (in Grauwerten) zusammen mit einer Grauwerteskala (in ppb/K), |
| **Figur 2** | das dCTE-Verteilungsprofil von Fig. 1 in einem Schnitt durch den Mittelpunkt in einer Diagrammdarstellung, |
| **Figur 3** | das dCTE-Verteilungsprofil von Fig. 1 mit eingezeichneter hypothetischer CA mit Fünfeckform und sechs Verteilungsprofil-Schnittlinien S1 bis S6, |
| **Figur 4** | ein dCTE-Verteilungsprofil gemäß der Erfindung, das durch laterale Verformung erzeugt worden ist, mit eingezeichneter CA mit Fünfeckform, Isolinien und Verteilungsprofil-Schnittlinien S1 bis S7, |
| **Figur 5** | ein Diagramm, das den dCTE-Verlauf des Profils von Fig. 3 entlang der normierten Schnittlinien S1 bis S6 zeigt, |
| **Figur 6** | ein Diagramm, das den dCTE-Verlauf von Fig. 4 entlang der normierten Schnittlinien S1 bis S7 zeigt, |
| **Figur 7** | ein Diagramm mit zwei Kurven, die den dCTE-Verlauf entlang der CA-Umrisslinie beim Verteilungsprofil von Fig. 3 beziehungsweise den dCTE-Verlauf entlang der CA-Umrisslinie beim Verteilungsprofil von Fig. 4 zeigen, |
| **Figur 8** | das dCTE-Verteilungsprofil von Fig. 3 mit eingezeichneter hypothetischer CA mit Ellipsenform und Verteilungsprofil-Schnittlinien, |
| **Figur 9** | ein dCTE-Verteilungsprofil gemäß der Erfindung, das durch laterale Verformung erzeugt worden ist, mit eingezeichneter CA mit Ellipsenform, Isolinien und Verteilungsprofil-Schnittlinien, |
| **Figur 10** | ein Diagramm, das den dCTE-Verlauf des Profils von Fig. 8 entlang der normierten Schnittlinien zeigt, |
| **Figur 11** | ein Diagramm, das den dCTE-Verlauf von Fig. 9 entlang der normierten Schnittlinien zeigt, |
| **Figur 12** | ein Diagramm mit zwei Kurven, die den dCTE-Verlauf entlang der CA-Umrisslinie beim Verteilungsprofil von Fig. 8 beziehungsweise den dCTE-Verlauf entlang der CA-Umrisslinie beim Verteilungsprofil von Fig. |

9 zeigen,

**Figur 13** ein zweites dCTE-Verteilungsprofil mit eingezeichneter hypothetischer CA mit Rechteckform und drei Verteilungsprofil-Schnittlinien S1, S2, S3,

**Figur 14** ein dCTE-Verteilungsprofil gemäß der Erfindung, das durch laterale Verformung einer runden Ausgangsplatte erzeugt worden ist, mit eingezeichneter CA mit Rechteckform, Isolinien und drei Verteilungsprofil-Schnittlinien S1, S2, S3,

**Figur 15** ein Diagramm mit drei Kurven, die den dCTE-Verlauf des Profils von Fig. 13 entlang der normierten Schnittlinien S1, S2, S3 zeigen,

**Figur 16** ein Diagramm mit drei Kurven, die den dCTE-Verlauf von Fig. 14 entlang der normierten Schnittlinien S1, S2, S3 zeigen,

**Figur 17** ein drittes rotationssymmetrisches dCTE-Verteilungsprofil mit eingezeichneter hypothetischer CA mit elliptischer Form und Verteilungsprofil-Schnittlinien S1 bis S6,

**Figur 18** ein dCTE-Verteilungsprofil gemäß der Erfindung, das durch laterale Verformung erzeugt worden ist, mit eingezeichneter CA mit elliptischer Form, Isolinien und Verteilungsprofil-Schnittlinien,

**Figur 19** ein Diagramm, das den dCTE-Verlauf des Profils von Fig. 17 entlang der normierten Schnittlinien zeigt,

**Figur 20** ein Diagramm, das den dCTE-Verlauf von Fig. 18 entlang der normierten Schnittlinien zeigt,

**Figur 21** ein spezifisches Ausführungsbeispiel eines Spiegelsubstrat-Rohlings mit Dreiecksform, einliegend in der zur Herstellung eingesetzten Schmelzform in einer Draufsicht.

## Erstes Verfahren zur Herstellung eines zylinderförmigen Vorprodukts für einen Spiegelsubstrat-Rohling

Durch Flammenhydrolyse von Octamethylcyclotetrasiloxan (OMCTS) und Titan-Isopropoxid $[Ti(O^iPr)_4]$ als Ausgangssubstanzen für die Bildung von $SiO_2$-$TiO_2$-Partikeln wird mit Hilfe des OVD-Verfahrens ein Sootkörper hergestellt, der mit ca. 8 Gew.-% $TiO_2$ dotiert ist.

Der Sootkörper wird bei einer Temperatur von 1150 °C in einem Heizofen mit einem Heizelement aus Grafit unter Vakuum dehydratisiert. Die Dehydratationsbehandlung endet nach 2 Stunden.

Danach wird der so getrocknete Sootkörper in einem Sinterofen bei einer Temperatur von ca. 1500 °C unter vermindertem Druck ($10^{-2}$ mbar) zu einem transparenten Rohling aus $TiO_2$ - $SiO_2$-Glas verglast. Der mittlere OH-Gehalt des Glases liegt bei etwa 170 Gew.-ppm.

Das Glas wird anschließend durch thermisch mechanische Homogenisierung (Verdrillen) und Bildung eines Zylinders aus $TiO_2$-$SiO_2$-Glas homogenisiert. Hierzu wird ein stabförmiger Ausgangskörper in eine mit einem Knallgasbrenner ausgestattete Glasdrehbank eingespannt und anhand eines Umformprozesses homogenisiert, wie er in der EP 673 888 A1 zum Zweck der vollständigen Entfernung von Schichten beschrieben ist. Dabei wird der Ausgangskörper mittels des Knallgasbrenners lokal auf über 2.000 °C erhitzt und dabei erweicht. Dabei werden dem Knallgasbrenner auf 1 Mol Sauerstoff 1,8 Mol Wasserstoff zugeführt und damit eine oxidierend wirkende Knallgasflamme erzeugt.

Durch Relativbewegung der beiden Halterungen zueinander wird der Ausgangskörper um seine Längsachse verdrillt, wobei die erweichte Glasmasse unter Bildung eines Drillkörpers in radialer Richtung über die gesamte Länge des Ausgangskörpers intensiv durchmischt wird. Auf diese Weise wird ein länglicher Drillkörper mit einem Durchmesser von etwa 90 mm und einer Länge von etwa 960 mm erhalten.

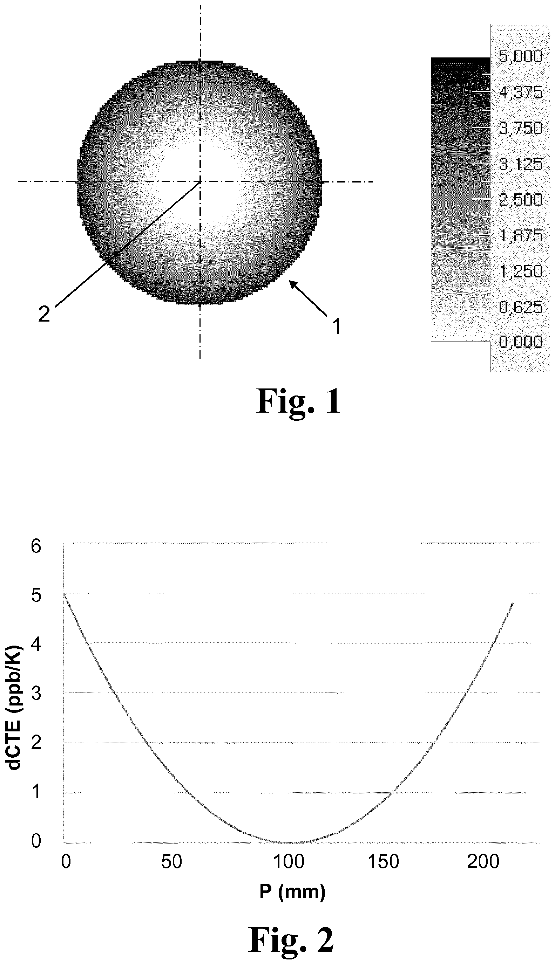

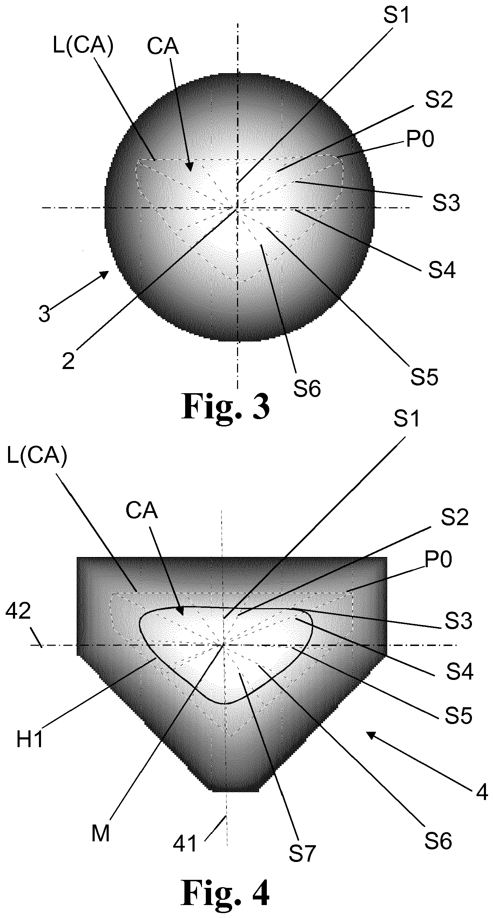

Aus dem Drillkörper wird eine runde Ausgangsplatte aus $TiO_2$-$SiO_2$-Glas mit einem Durchmesser von 200 mm und einer Dicke von 195 mm geformt. **Figur 1** zeigt eine Falschfarbendarstellung (Grauschattierungen) des über die Dicke der Ausgangsplatte 1 gemessenen dCTE-Verteilungsprofils in einer Draufsicht auf die Plattenoberseite. Gemäß der rechts von Fig. 1 gezeigten Graustufenskala liegen die relativen dCTE-Werte zwischen Null und 5 ppb/K. Diese Graustufenskala liegt auch den Falschfarbendarstellung (Grauschattierungen) der Figuren 3, 4, 8, 9, 13, 14, 18 und 19 zugrunde.

Das Verteilungsprofil ist im Wesentlichen rotationssymmetrisch in Bezug auf die Platten-Mittelachse 2, wobei die dCTE-Werte von außen nach innen abfallen. Der relative Nullwert (der minimale CTE-Wert des Profils) liegt auf der Mittelachse 2.

Dies zeigt auch das Diagramm von **Figur 2,** in dem das dCTE-Verteilungsprofil der Ausgangsplatte 1 in einem Schnitt durch die Mittelachse 2 dargestellt ist. Dabei ist der dCTE-Wert in ppb/K gegen die Position P (Durchmesser) in mm aufgetragen. Demnach nimmt dCTE von einem Wert von etwa 5 ppb/K gleichmäßig nach innen bis auf Null ab. Die Gesamtinhomogenität $dCTE_{max}$ als Differenz zwischen dem Inhomogenitäts-Maximalwert am Rand und dem Inhomogenitäts-Minimalwert (Null) in der Mitte beträgt demnach 5 ppb/K.

Der maximale Unterschied der CTE-Werte ist mit 5 ppb/K relativ gering. Die Unterschiede beruhen in erster Linie auf Schwankungen der $TiO_2$-Konzentration und auf Fluktuationen der fiktiven Temperatur. Auf diesem relativ niedrigen dCTE-Niveau können geringfügige Schwankungen im Fertigungsprozess - beispielsweise beim Abscheide- oder beim Homogenisierungsschritt - zu grundlegend anderen dCTE-Verteilungsprofilen führen. Insbesondere wird häufig ein gegenüber Fig. 1 horizontal gespiegeltes Verteilungsprofil erhalten mit einem CTE-Maximalwert im Bereich der Mittelachse und dem dCTE-Nullwert am Rand.

Für die vorliegende Erfindung ist jedoch wichtig, dass das dCTE-Verteilungsprofil der jeweiligen Ausgangsplatte im Wesentlichen rotationssymmetrisch ist. Dies wird im Ausführungsbeispiel durch den Homogenisierungsprozess gewährleistet.

Derartige runde Ausgangsplatten sind Ausgangspunkt für die Herstellung unterschiedlicher Formkörper, wie dies im Folgenden anhand von Beispielen erläutert wird.

Beispiel 1 - Herstellung des Spiegelsubstrat-Rohlings aus dem Vorprodukt

Die Ausgangsplatte 1 aus $TiO_2$-$SiO_2$-Glas mit einem Durchmesser von 200 mm und einer Dicke von 195 mm wird in einem Ofen durch laterale Umformung zu einer Polygonplatte 4 mit fünf Ecken umgeformt, wie schematisch in **Figur 4** gezeigt. Hierzu wird die Ausgangsplatte 1 mittig in eine Schmelzform aus Grafit eingelegt, die einen fünfeckigen Innenquerschnitt aufweist, ähnlich wie dies weiter unten noch für eine Umformung in eine Platte mit dreieckigem Querschnitt näher erläutert wird. Die Schmelzform wird evakuiert und auf 1350 °C und anschließend mit einer Rampe 9 °C/min auf 1700 °C aufgeheizt, und danach mit einer Rampe von 2 °C/min auf eine Temperatur von 1780 °C. Bei dieser Temperatur erweicht die Quarzglasmasse und das erweichte Quarzglas verformt sich unter seinem eigenen Gewicht und dem Gewicht einer zur Beschleunigung zusätzlich aufgelegten Grafitplatte und fließt in lateraler Richtung aus und füllt dabei den Boden der Schmelzform vollständig aus.

Die so erhaltene Fünfeckplatte 4 (Fig. 4) besteht aus homogenisiertem, hochkieselsäurehaltigem Glas, das 8 Gew.-% Titanoxid und einen mittleren Hydroxylgruppengehalt um 170 Gew.-ppm enthält. **Figur 4** zeigt eine Falschfarbendarstellung des dCTE-Verteilungsprofils (als Grauschattierung mit der Graustufenskala von Fig. 1), gemessen über die Plattendicke der Fünfeckplatte 4 in einer Draufsicht auf deren Oberseite. Das dCTE-Verteilungsprofil ist nun nicht mehr rotationssymmetrisch wie bei der Ausgangsplatte 1, sondern im Wesentlichen polygonal mit Spiegelsymmetrie bezüglich der Mittelachse 41. Bezogen auf den gesamten Querschnitt der Fünfeckplatte sind die dCTE-Extremwerte mit 5 ppb/K und 0 ppb/K die gleichen wie bei der Ausgangsplatte 1.

Zum Vergleich zeigt **Figur 3** ein hypothetisches dCTE-Verteilungsprofil einer aus der Ausgangsplatte 1 durch Ausfließenlassen herstellbaren Rundplatte 3. Diese ist nicht Gegenstand der vorliegenden Erfindung, sondern dient lediglich zu Vergleichszwecken. Die Umformung der Ausgangsplatte 1 erfolgt hierbei durch Ausfließlassen in eine Schmelzform mit rundem Querschnitt. Die Ausgangsplatte wird dabei mittig innerhalb der Schmelzform mit vertikal orientierter Längsachse aufgestellt. Das erweichte Quarzglas, fließt in lateraler Richtung aus und füllt dabei den Boden der Schmelzform vollständig aus. Die so geformte Rundplatte 3 hat einen Durchmesser von 280 mm und eine Dicke von 100 mm.

Bei der hypothetischen Verformung zur Rundplatte 3 bewegt sich die zähflüssige Quarzglasmasse des Ausgangsplatte 1 in Richtung des umlaufenden Schmelzformrandes und erreicht diesen theoretisch an allen Stellen gleichzeitig. Das dCTE-Verteilungsprofil der Rundplatte 3 ist somit in allen Schnitten durch den Mittepunkt 2 identisch zu dem in Fig. 2 gezeigten Profil.

Im Unterschied dazu trifft die erweichte Quarzglasmasse bei der Verformung der Ausgangsplatte1 zur Fünfeckeckplatte 4 in mindestens einer Richtung relativ frühzeitig auf eine Hindernis und staut sich an diesem auf, während sie ansonsten in anderer Richtungen weiter frei ausfließen kann. In diesen Richtungen wird das dCTE-Verteilungsprofil somit gegenüber der anderen Richtung stärker gestreckt. Daher ist das dCTE-Verteilungsprofil der Fünfeckplatte 4 in einem Schnitt durch die Platten-Mittelachse M entlang der relativ kurzen Spiegelachse 41 ebenfalls nahezu identisch zu dem in Fig. 2 gezeigten Profil, jedoch in dem relativ langen Schnitt durch die Platten-Mittelachse M entlang der dazu senkrecht verlaufenden Achse 42 stärker gestreckt.

Unabhängig davon besteht zwischen den dCTE-Verteilungsprofilen der ursprünglichen Ausgangsplatte 1, der Rundplatte 3 und der Fünfeckplatte 4 "Ähnlichkeit" in dem Sinn, dass die wesentlichen Merkmale des dCTE-Verteilungsprofils in der Fünfeckform, nämlich die Anzahl der relativen und absoluten Extremwerte der Verteilung als auch deren relative Lage zueinander dieselben sind wie in der Ausgangsplatte 1 und in der Rundplatte 3. Insoweit erfüllt das dCTE-Verteilungsprofil von Fig. 4 bereits einen Teil der oben erläuterten Grundbedingungen, die dem Konstruktionsprinzip für einen Spiegelsubstrat-Rohling gemäß dieser Erfindung zugrunde liegen. Es ist nicht rotationssymmetrisch, aber durch "geometrische Transformation" - unter Berücksichtigung einfacher Streckverformungen - ist es in die ursprünglich rotationssymmetrische Verteilung der Rundform der Ausgangsplatte 1 mathematisch eindeutig überführbar.

Im Vergleich zu dem ursprünglichen, rotationssymmetrischen Verteilungsprofil zeigt das dCTE-Verteilungsprofil von Fig. 4 darüber hinaus im Zusammenspiel mit einer nicht kreisrunden optisch benutzten Fläche CA eine Interaktion mit vergleichsweise geringer Beeinträchtigung der Abbildungsqualität des Spiegels. Dies wird im Folgenden näher erläutert:

(a) Bandbreite von Schnittlinien

In Fig. 3 ist ergänzend zu Fig. 1 schematisch die Umrisslinie L(CA) einer optisch genutzten Fläche CA mit Fünfeckform und abgerundeten Kanten eingezeichnet. Innerhalb von CA sind mehrere durch den Mittelpunkt 2 verlaufende Schnittlinien S1 bis S6 eingetragen. Der Mittelpunkt 2 bildet gleichzeitig den Flächenschwerpunkt von CA.

Sofern hier um im Folgenden dCTE-Werte genannt werden, so beziehen sich diese auf den Bereich innerhalb von CA. Die dCTE-Werte berechnen sich demnach als Betrag der örtlichen Abweichung von einem absoluten Minimalwert $CTE_{min}$ des CTE-Verteilungsprofils innerhalb von CA ($dCTE=CTE-CTE_{min}$)

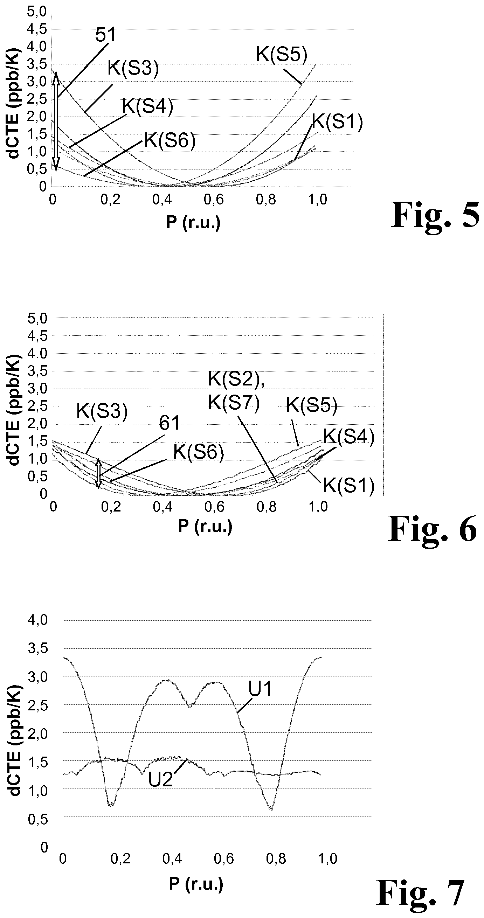

Das Diagramm von **Figur 5** zeigt die dCTE-Verteilungsprofile entlang dieser Schnittlinien S1 bis S6 (innerhalb von CA; nur die markantesten und für die Beurteilung relevanten Schnittlinien sind mit Bezugzeichen versehen). Auf der Ordinate des Diagramms ist der betreffende dCTE-Wert (in ppb/K) aufgetragen und auf der Abszisse ein auf die jeweilige Schnittlinienlänge normierter Positionswert P (in relativer Einheit), der somit den Bereich von 0 bis 1 abdeckt. Die maximale Inhomogenität $dCTE_{max}$ innerhalb von CA beträgt demnach etwa 3,4 ppb/K. Der Minimalwert $dCTE_{min}$ innerhalb von CA ist definitionsgemäß = Null. Zwischen den Schnittprofilen K(S3) und K(S5) einerseits und den Schnittprofilen K(S1) und K(S6) andererseits zeigen sich deutlich unterschiedliche dCTE-Werte im Bereich der Randpositionen 0 und 1. Im Maximum (markiert mit Blockpfeil 51) liegt die Differenz bei etwa 2,8 ppb/K. Das Maximum 51 repräsentiert die maximale Bandbreite der von den Kurven K(S1) bis K(S6) gebildeten Kurvenschar; es beträgt etwa 82% von $dCTE_{max}$ (3,4 ppb/K).

Auch im Verteilungsprofil von Fig. 4 ist schematisch dieselbe Umrisslinie L(CA) der optisch genutzten Fläche CA mit Fünfeckform und abgerundeten Kanten eingezeichnet. Der Flächenschwerpunkt von CA liegt im Punkt M. Das Diagramm von **Figur 6** zeigt die dCTE-Verteilungsprofile entlang einiger markanter Schnittlinien S1 bis S6 (innerhalb von CA) beim dCTE-Verteilungsprofil von Fig. 4. Auch hier ist auf der Ordinate des Diagramms der betreffende dCTE-Wert (in ppb/K) aufgetragen und auf der Abszisse der auf die jeweilige Schnittlinienlänge normierte Positionswert. Daraus ist ersichtlich, dass alle Schnittprofile K(S1) bis K(S6) relativ ähnlich sind und ein schmales Kurvenband bilden. Die maximale Inhomogenität $dCTE_{max}$ innerhalb von CA beträgt demnach etwa 1,6 ppb/K. Der maximale Unterschied der dCTE-Werte (markiert mit Blockpfeil 61) beträgt nur etwa 0,75 ppb/K. Die maximale Bandbreite der von den Kurven K(S1) bis K(S6) gebildeten Kurvenschar (Maximum 61) liegt hier demnach bei etwa47 % von $dCTE_{max}$. Zudem ist es mit Nutzung des gleichen Ausgangsmaterials gelungen, dCTEmax innerhalb der CA-Fläche von 3,4ppb/K (siehe Fig. 3 und 5) auf 1,6ppb/K (siehe Fig. 4 und 6) zu reduzieren, was mit einer verbesserten Abbildungsqualität in der Anwendung als Spiegel für die EUV-Lithographie einhergeht.

(b) Höhenunterschied auf der CA-Umrisslinie L(CA)

Das Diagramm von **Figur 7** zeigt einen Vergleich der Verläufe des dCTE-Verteilungsprofils entlang der CA-Umrisslinien L(CA) bei den Rohlingen der Figuren 3 und 4, jeweils bei einem Umlauf im Uhrzeigersinn beginnend und endend bei Position P0 (Position P0 markiert in den Figuren 3 und 4). Auf der y-Achse ist der dCTE-Wert in ppb/K gegen die auf die jeweilige Länge der Umrisslinie L(CA) normierte Position P (in relativer Einheit) aufgetragen (die Längen der Umrisslinien L(CA) sind in diesem Fall identisch).

Die Kurve U1 repräsentiert den Verlauf des dCTE-Verteilungsprofils entlang der CA-Umrisslinie L(CA) beim Rohling von Fig. 3. Daraus ergibt sich ein Differenzbetrag $PV_{CA}$ zwischen den dCTE-Extremwerten (Höchstwert (3,4 ppb/K) und Niedrigstwert (0,7 ppb/K) von 2,7 ppb/K entlang der CA-Umrisslinie L(CA). $PV_{CA}$ beträgt demnach etwa $0,79xdCTE_{max}$. Die Kurve U2 repräsentiert den Verlauf des dCTE-Verteilungsprofils entlang der CA-Umrisslinie L(CA) beim Rohling von Fig. 4. Daraus ergibt sich ein Differenzbetrag $PV_{CA}$ zwischen den dCTE-Extremwerten (Höchstwert (1,6 ppb/K) und Niedrigstwert (1,2 ppb/K) von 0,4 ppb/K entlang der CA-Umrisslinie L(CA). $PV_{CA}$ beträgt demnach etwa $0,25xdCTE_{max}$.

Im Vergleich zum dCTE-Verteilungsprofil von Fig. 3 zeigt der Spiegelsubstrat-Rohling 4 ein besseres Abbildungsverhalten bei optischer Belastung mit der nicht-kreisrunden CA. Dies kann darauf zurückgeführt werden, dass das dCTE-Verteilungsprofil gut der Form von CA angepasst ist, und so ausgelegt ist, dass die CA-Umrisslinie L(CA) von möglichst wenigen Isolinien des Verteilungsprofils geschnitten wird.

(c) Verlauf der Isolinie mit dem Niveau 0,5 x $dCTE_{max}$,

In Fig. 4 ist schematisch eine Isolinie H1 für den dCTE-Wert von 0,5 x $dCTE_{max}$ eingezeichnet. Es ist erkennbar, dass die Isolinie H1 mit ihrer gesamten Isolinienlänge innerhalb der Umrisslinie L(CA) der optisch genutzten Fläche CA verläuft. Das bedeutet, dass die Form des dCTE-Inhomogenitäts-Profils beim Spiegelsubstrat-Rohling 4 von Fig. 4 der Umrisslinie L(CA) insoweit angepasst ist, dass die CA-Umrisslinie L(CA) von möglichst wenigen Isolinien des Verteilungsprofils geschnitten wird.

Damit erfüllt Rohling 4 in Verbindung mit seiner spezifischen, optisch genutzten Fläche CA in Fünfeckform alle Bedingungen des allgemeinen Konstruktionsprinzips gemäß der Erfindung, nämlich die Anforderung an das dCTE-Verteilungsprofil des Rohlings und das Zusammenspiel zwischen dem dCTE-Verteilungsprofil und der optisch beanspruchten Fläche CA mit nicht-kreisrunder Umrisslinie L(CA).

Beispiel 2

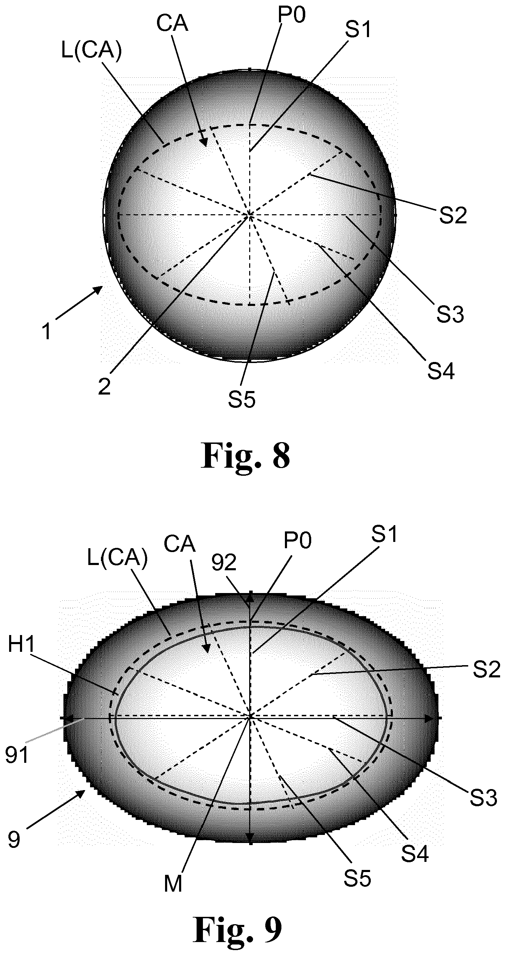

In einem weiteren Beispiel der Erfindung wird die Ausgangsplatte 1 aus $TiO_2$-$SiO_2$-Glas mit einem Durchmesser von 200 mm und einer Dicke von 195 mm in einem Ofen durch laterale Umformung zu einer Platte 9 mit ovalem Querschnitt umgeformt, wie schematisch in **Figur 9** gezeigt. Hierzu wird die Ausgangsplatte 1 mittig in eine Schmelzform aus Grafit eingelegt, die einen ovalen Innenquerschnitt aufweist. Die laterale Verformung durch Erweichen und Ausfließenlassen in die Schmelzform erfolgt ansonsten, wie anhand Beispiel 1 bereits erläutert. Im Vergleich zur Ausgangsplatte 1 von Fig. 1 beträgt das Verhältnis der langen Oval-Halbachse 91 zu der kurzen Achse 92 etwa 1,45.

Die so erhaltene ovale Platte 9 besteht aus homogenisiertem, hochkieselsäurehaltigem Glas, das 8 Gew.-% Titanoxid und einen mittleren Hydroxylgruppengehalt um 170 Gew.-ppm enthält.

Die Falschfarbendarstellung von Fig. 9 (als Grauschattierung mit der Graustufenskala von Fig. 1) zeigt nahezu Spiegelsymmetrie bezüglich der Hauptachsen 91 und 92 des Ovals. Die dCTE-Extremwerte (5 ppb/K) und (0 ppb/K) innerhalb der gesamten Fläche des Rohlings 9 sind die gleichen wie bei der Ausgangsplatte 1. Zwischen den dCTE-Verteilungsprofilen der Ausgangsplatte 1 und der Platte 9 mit ovalem Querschnitt besteht "Ähnlichkeit" in dem Sinn, dass die wesentlichen Merkmale des dCTE-Verteilungsprofils in der ovalen Form, nämlich die Anzahl der relativen und absoluten Extremwerte der Verteilung als auch deren relative Lage zueinander gleich sind. Insoweit erfüllt das dCTE-Verteilungsprofil von Fig. 9 bereits einen Teil der oben erläuterten Grundbedingungen, die dem Konstruktionsprinzip für einen Spiegelsubstrat-Rohling gemäß dieser Erfindung zugrunde liegen. Es ist nicht rotationssymmetrisch, aber durch "geometrischeTransformation" - unter Berücksichtigung einfacher Streckverformungen - ist es in die ursprünglich rotationssymmetrische Verteilung mathematisch eindeutig überführbar.

Im Vergleich zu einem rotationssymmetrischen Verteilungsprofil zeigt das dCTE-Verteilungsprofil von Fig. 9 darüber hinaus im Zusammenspiel mit einer nicht kreisrunden optisch benutzten Fläche CA eine Interaktion mit vergleichsweise geringer Beeinträchtigung der Abbildungsqualität des Spiegels. Dies wird im Folgenden näher erläutert:

(a) Bandbreite von Schnittlinien

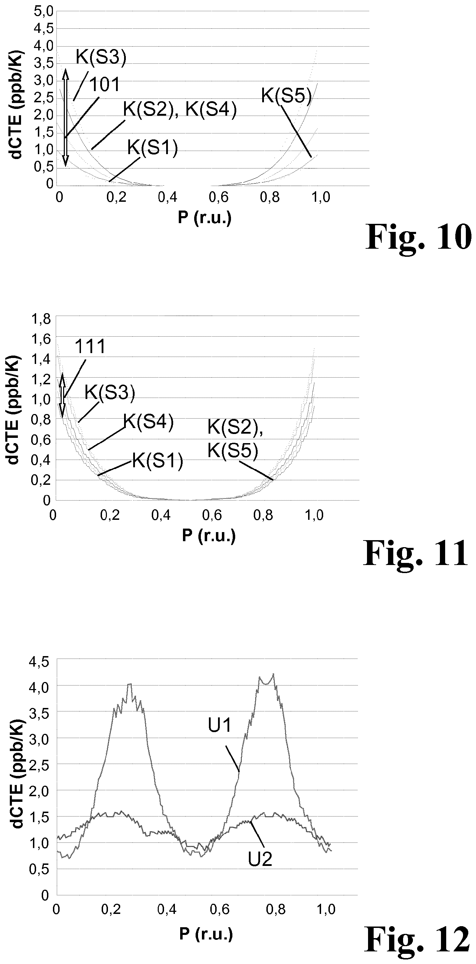

Zum Vergleich zeigt **Figur 8** wiederum die Rundplatte 3 (wie zu Fig. 3 erläutert). Darin ist schematisch die Umrisslinie L(CA) einer optisch genutzten Fläche CA eingezeichnet, die als "ellipsenförmig" bezeichnet werden kann. Innerhalb von CA sind mehrere durch den Mittelpunkt 2 verlaufende Schnittlinien S1 bis S5 eingetragen. Der Mittelpunkt 2 bildet gleichzeitig den Flächenschwerpunkt von CA. Das Diagramm von **Figur 10** zeigt die dCTE-Verteilungsprofile entlang dieser Schnittlinien S1 bis S5 (innerhalb von CA; nur die markantesten und für die Ermittlung der Breite der Kurvenschar wichtigen Linien sind mit Bezugszeichen versehen). Auf der Ordinate des Diagramms ist der betreffende dCTE-Wert (in ppb/K) aufgetragen und auf der Abszisse ein auf die jeweilige Schnittlinienlänge normierter Positionswert P (in relativer Einheit), der somit den Bereich von 0 bis 1 abdeckt. Zwischen den Schnittprofilen K(S1) bis K(S5) zeigen sich deutlich unterschiedliche dCTE-Werte im Bereich der Randpositionen 0 und 1. $dCTE_{max}$ innerhalb von CA liegt bei 3,9 ppb/K. Im Bandbreiten-Maximum (markiert mit Blockpfeil 101) liegt die Differenz zwischen Minimalwert und Maximalwert bei etwa 3,1 ppb/K. Das Maximum 101 repräsentiert die maximale Bandbreite der von den Kurven K(S1) bis K(S5) gebildeten Kurvenschar; es beträgt etwa 79% von $dCTE_{max}$.

Auch in der Verteilungsprofil von Fig. 9 ist schematisch dieselbe Umrisslinie L(CA) der optisch genutzten Fläche CA mit elliptischer Form eingezeichnet. Der Flächenschwerpunkt von CA liegt im Punkt M. Das Diagramm von **Figur 11** zeigt die dCTE-Verteilungsprofile entlang von Schnittlinien S1 bis S5 (innerhalb von CA) beim dCTE-Verteilungsprofil von Fig. 9. Auch hier ist auf der Ordinate des Diagramms der betreffende dCTE-Wert (in ppb/K) aufgetragen und auf der Abszisse der auf die jeweilige Schnittlinienlänge normierte Positionswert P (in relativen Einheiten). Daraus ist ersichtlich, dass alle Schnittprofile K(S1) bis K(S6) relativ ähnlich sind und ein schmales Kurvenband bilden. Der maximale Unterschied der dCTE-Werte (markiert mit Blockpfeil 111) beträgt nur etwa 0,6ppb/K. Die maximale Inhomogenität $dCTE_{max}$ innerhalb von CA beträgt demnach etwa 1,55 ppb/K. Die maximale Bandbreite der von den Kurven K(S1) bis K(S5) gebildeten Kurvenschar (Maximum 111) liegt hier demnach bei etwa 39% von $dCTE_{max}$.

(b) Höhenunterschied auf der CA-Umrisslinie L(CA)

Das Diagramm von **Figur 12** zeigt einen Vergleich der Verläufe des dCTE-Verteilungsprofils entlang der CA-Umrisslinien L(CA) bei den Rohlingen der Figuren 8 und 9, jeweils bei einem Umlauf im Uhrzeigersinn beginnend und endend bei Position P0. Auf der y-Achse ist der dCTE-Wert (in ppb/K) gegen die auf die jeweilige Länge der Umrisslinie L(CA) normierte Position P aufgetragen (die Längen der Umrisslinien L(CA) sind auch hier identisch).

Die Kurve U1 repräsentiert den Verlauf des dCTE-Verteilungsprofils entlang der CA-Umrisslinie L(CA) beim Rohling von Fig. 8. Daraus ergibt sich ein Differenzbetrag $PV_{CA}$ zwischen den dCTE-Extremwerten (Höchstwert (4 ppb/K) und Niedrigstwert (0,8 ppb/K) von 3,2 ppb/K entlang der CA-Umrisslinie L(CA). $PV_{CA}$ beträgt demnach etwa $0,80 \times dCTE_{max}$.

Die Kurve U2 repräsentiert den Verlauf des dCTE-Verteilungsprofils entlang der CA-Umrisslinie L(CA) beim Rohling von Fig. 9. Daraus ergibt sich ein Differenzbetrag $PV_{CA}$ zwischen den dCTE-Extremwerten (Höchstwert (1,5 ppb/K) und Niedrigstwert (1 ppb/K) von 0,5 ppb/K entlang der CA-Umrisslinie L(CA). $PV_{CA}$ beträgt demnach etwa $0,33 \times dCTE_{max}$.

(c) Verlauf der Isolinie mit dem Niveau $0,5 \times dCTE_{max}$,

In Fig. 9 ist schematisch eine Isolinie H1 für den dCTE-Wert von $0,5 \times dCTE_{max}$ eingezeichnet. Es ist erkennbar, dass die Isolinie H1 mit nahezu ihrer gesamten Isolinienlänge (mit mehr als 80% ihrer Länge) innerhalb der Umrisslinie L(CA) der optisch genutzten Fläche CA verläuft. Das bedeutet, dass die Form des dCTE-Inhomogenitäts-Profils beim Spiegelsubstrat-Rohling 9 von Fig. 9 der Umrisslinie L(CA) insoweit angepasst ist, dass die CA-Umrisslinie L(CA) von möglichst wenigen Isolinien des Verteilungsprofils geschnitten wird.

Damit erfüllt auch Rohling 9 in Verbindung mit seiner spezifischen, optisch genutzten Fläche CA alle Bedingungen des allgemeinen Konstruktionsprinzips gemäß der Erfindung, nämlich die Anforderung an das dCTE-Verteilungsprofil des Rohlings und das Zusammenspiel zwischen dem dCTE-Verteilungsprofil und der optisch beanspruchten Fläche CA mit nicht-kreisrunder Umrisslinie L(CA).

Zweites Verfahren zur Herstellung eines zylinderförmigen Vorprodukts für einen Spiegelsubstrat-Rohling

Durch Flammenhydrolyse von Octamethylcyclotetrasiloxan (OMCTS) und Titan-Isopropoxid $[Ti(O^iPr)_4]$ als Ausgangssubstanzen für die Bildung von $SiO_2$-$TiO_2$-Partikeln wird mit Hilfe des OVD-Verfahrens ein Sootkörper hergestellt, der mit ca. 8 Gew.-% $TiO_2$ dotiert ist. Im Vergleich zur oben erläuterten, ersten Verfahrensweise wird während des gesamten Abscheideprozesses die Oberflächen-Temperatur des Sootkörpers geringfügig höher gehalten. Dieser kleine Unterschied führt zu einer anderen Verteilung der $TiO_2$-Konzentration.

Beispiel 3

Die Ausgangsplatte aus $TiO_2$-$SiO_2$-Glas mit einem Durchmesser von 200 mm und einer Dicke von 195 mm wird in einem Ofen durch laterale Umformung zu einer Rechteckplatte mit den seitlichen Abmessungen 400 mm x 250 mm und einer Dicke von 60 mm umgeformt. Hierzu wird die Ausgangsplatte mittig in eine Schmelzform aus Grafit eingelegt, die einen rechteckigen Innenquerschnitt mit einer kurzen Seite b=250 mm und einer langen Seite a=400 mm eingebracht. Die laterale Verformung durch Erweichen und Ausfließenlassen in die Schmelzform erfolgt ansonsten, wie anhand Beispiel 1 bereits erläutert.

Die so erhaltene Rechteckplatte 14 besteht aus homogenisiertem, hochkieselsäurehaltigem Glas, das 8 Gew.-% Titanoxid und einen mittleren Hydroxylgruppengehalt um 170 Gew.-ppm enthält.

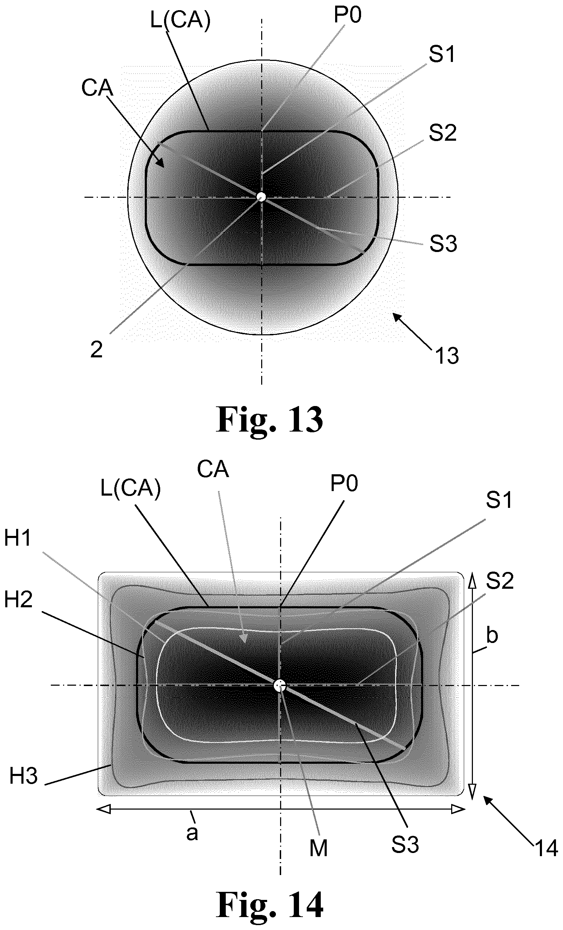

Die Falschfarbendarstellung von **Figur 14** (als Grauschattierung mit der Graustufenskala von Fig. 1) zeigt das dCTE-Verteilungsprofil gemessen über die Plattendicke der Rechteckplatte 14 mit den Plattenseiten a und b in einer Draufsicht auf deren Oberseite. Das dCTE-Verteilungsprofil ist nun nicht mehr rotationssymmetrisch wie bei der zum Vergleich in Fig. 13 schematisch dargestelltem Rundplatte 13 aus derselben Ausgangsplatte, sondern es hat eine annähernd 2-achsige Symmetrie mit den beiden Hauptachsen a und b der Rechteckplatte 14 als Spiegelachsen. Die dCTE-Werte nehmen bei diesem Profil von außen nach innen bis zur Mittelachse M zu. Der relative Extremwert dCTEmax über den gesamten Rohling gesehen liegt bei 5 ppb/K.

Die Verformung der Ausgangsplatte zur Rechteckplatte 14 unterscheidet sich von der Verformung zur Rundplatte 13 (wie in Fig. 13 dargestellt; deren dCTE-Verteilungsprofil entspricht demjenigen der Ausgangsplatte) darin, dass in Richtung der langen Plattenseite eine größere Streckung (Streckfaktor gegenüber der Ausgangsplatte = 2) stattgefunden hat als in Richtung der kurzen Plattenseite b (Streckfaktor = 1,25). Daher ist das dCTE-Verteilungsprofil in einem Schnitt durch die Platten-Mittelachse M entlang der langen Plattenseite a im Vergleich zu dem Profil der Rundplatte 13 von Fig. 13 gestreckt; und in Richtung der kurzen Plattenseite b ist es nahezu identisch zu dem in Fig. 13 gezeigten Profil.

Zwischen den dCTE-Verteilungsprofilen der ursprünglichen Ausgangsplatte und der Rechteckplatte 14 besteht "Ähnlichkeit" in dem Sinn, dass die wesentlichen Merkmale des dCTE-Verteilungsprofils in der Rechteckform, nämlich die Anzahl der relativen und absoluten Extremwerte der Verteilung als auch deren relative Lage zueinander dieselben sind wie in der Ausgangsplatte. Insoweit erfüllt das dCTE-Verteilungsprofil von Fig. 14 bereits einen Teil der oben erläuterten Grundbedingungen, die dem Konstruktionsprinzip für einen Spiegelsubstrat-Rohling gemäß dieser Erfindung zugrunde liegen. Es ist nicht rotationssymmetrisch, aber durch "geometrische Transformation" - unter Berücksichtigung einfacher Streckverformungen - ist es in die ursprünglich rotationssymmetrische Verteilung der Rundform der Ausgangsplatte mathematisch eindeutig überführbar.

Im Vergleich zu diesem rotationssymmetrischen Verteilungsprofil zeigt das dCTE-Verteilungsprofil von Fig. 14 darüber hinaus im Zusammenspiel mit einer nicht kreisrunden optisch benutzten Fläche CA eine Interaktion mit vergleichsweise geringer Beeinträchtigung der Abbildungsqualität des Spiegels. Dies wird im Folgenden näher erläutert:

(a) Bandbreite von Schnittlinien

In **Figur 13** ist schematisch die Umrisslinie L(CA) einer optisch genutzten Fläche CA mit Rechteckform und abgerundeten Kanten eingezeichnet. Innerhalb von CA sind drei durch den Mittelpunkt 2 verlaufende Schnittlinien S1, S2 und S3 eingetragen. S1 verläuft entlang der kurzen Achse der Rechtreckform, S2 entlang der langen Achse und S3 entlang der Diagonalen.

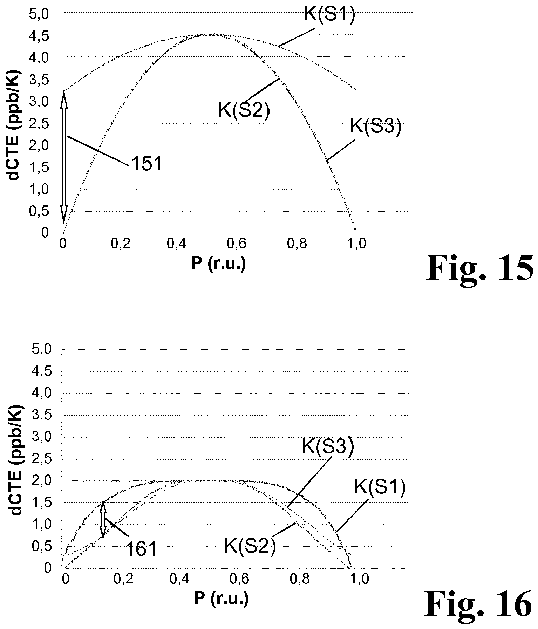

Das Diagramm von **Figur 15** zeigt die dCTE-Verteilungsprofile entlang dieser Schnittlinien S1 bis S3 (innerhalb von CA). Auf der Ordinate des Diagramms ist der betreffende dCTE-Wert (in ppb/K) aufgetragen und auf der Abszisse ein auf die jeweilige Schnittlinienlänge normierter Positionswert P (in relativen Einheiten), der somit den Bereich von 0 bis 1 abdeckt. Daraus ergibt sich, dass die Schnittprofile K(S2) und K(S3) entlang der langen Rechteckachse S2 beziehungsweise entlang der Diagonalen S3 ähnlich sind und fast übereinander zu liegen kommen, sich jedoch beide vom Schnittprofil K(S1) entlang der kurzen Rechteckachse S1 deutlich unterscheiden. Die dCTE-Werte aller Schnitte zeigen im jeweiligen Mittelbereich einen gemeinsamen Maximalwert mit $dCTE_{max}$=4,5ppb/K (berechnet als Differenz zwischen Höchstwert (5 ppb/K) und Minimalwert (0,5 ppb/K) innerhalb von CA). An den Randpositionen 0 und 1 zeigt sich jedoch ein großer Unterschied, der im Maximum (markiert mit Blockpfeil 151) etwa 3,3 ppb/K beträgt. Das Maximum 151 repräsentiert die maximale Bandbreite der von den Kurven K(S1), K(S2), und K(S3) gebildeten Kurvenschar, das bei etwa 73 % von $dCTE_{max}$. liegt.

Auch im Verteilungsprofil von Fig. 14 sind schematisch die Umrisslinie L(CA) der optisch genutzten Fläche CA mit Rechteckform und abgerundeten Kanten eingezeichnet. Der Flächenschwerpunkt von CA liegt in der Mittelachse M. Das Diagramm von **Figur 16** zeigt die dCTE-Verteilungsprofile entlang der Schnittlinien S1 bis S3 (innerhalb von CA) beim dCTE-Verteilungsprofil von Fig. 14 durch den Flächenschwerpunkt (Mittelpunkt M).

Auch hier ist auf der Ordinate des Diagramms der betreffende dCTE-Wert aufgetragen (in ppb/K) und auf der Abszisse der auf die jeweilige Schnittlinienlänge normierte Positionswert P (in relativer Einheit). Daraus ist ersichtlich, dass die Schnittprofile K(S2) und K(S3) ähnlich sind, sich jedoch vom Schnittprofil K(S1) entlang der kurzen Rechteckachse S1 weniger deutlich unterscheiden als beim Diagramm von Fig. 15. Der gemeinsame Maximalwert $dCTE_{max}$ innerhalb der CA-Fläche der Schnitte liegt wiederum im Mittelbereich, er beträgt jedoch nur noch 2 ppb/K (berechnet als Differenz zwischen Höchstwert (5 ppb/K) und Minimalwert (3 ppb/K) innerhalb von CA); der maximale Unterschied der dCTE-Werte der Kurvenschar an einer Position (markiert mit Blockpfeil 161) beträgt nur etwa 0,7 ppb/K. Die maximale Bandbreite der von den Kurven K(S1), K(S2), und K(S3) gebildeten Kurvenschar (Maximum 161) liegt hier demnach bei etwa 35 % von $dCTE_{max}$. Durch die geringeren Variationen in dCTE und die gleichmäßigeren Verläufe der Schnitte S1 bis S3 zeichnet sich dieses Verteilungsprofil gegenüber dem von Fig. 13/Fig. 15 durch bessere Anpassung an CA und bessere Abbildungseigenschaften aus.

(b) Verlauf der Isolinie mit dem Niveau 0,5 x $dCTE_{max}$,

In Fig. 14 sind schematisch Isolinien H1, H2, H3 eingezeichnet, die dCTE-Werte auf gleichem Niveau anzeigen. Dabei repräsentieren

• die Isolinie H3 einen dCTE-Wert von -1,2 x $dCTE_{max}$,

• die Isolinie H2 einen dCTE-Wert von 0,8 x $dCTE_{max}$, und

• die Isolinie H1 einen dCTE-Wert von 0,5 x $dCTE_{max}$.

Es ist erkennbar, dass die Isolinie H1 mit ihrer gesamten Isolinienlänge innerhalb der Umrisslinie L(CA) der optisch genutzten Fläche CA verläuft. Die Isolinie H2 verläuft mit etwa 15% ihrer gesamten Isolinienlänge außerhalb von CA, wohingegen die Isolinie H3 vollständig außerhalb von CA verläuft; sie gehört aber auch nicht zur optisch beanspruchten Fläche CA.

Das bedeutet, dass die Kontur des dCTE-Inhomogenitäts-Profils beim Spiegelsubstrat-Rohling von Fig. 14 der Umrisslinie L(CA) insoweit angepasst ist, dass die CA-Umrisslinie L(CA) von möglichst wenigen Isolinien des Verteilungsprofils geschnitten wird.

Damit erfüllt der Rohling 14 in Verbindung mit seiner spezifischen, optisch genutzten Fläche CA alle Bedingungen des allgemeinen Konstruktionsprinzips gemäß der Erfindung, nämlich die Anforderung an das dCTE-Verteilungsprofil des Rohlings und das Zusammenspiel zwischen dem dCTE-Verteilungsprofil und der optisch beanspruchten Fläche CA mit nicht-kreisrunder Umrisslinie L(CA).

Drittes Verfahren zur Herstellung eines zylinderförmigen Vorprodukts für einen Spiegelsubstrat-Rohling

Durch Flammenhydrolyse von Octamethylcyclotetrasiloxan (OMCTS) und Titan-Isopropoxid [Ti(O$^{i}$Pr)$_4$] als Ausgangssubstanzen für die Bildung von $SiO_2$-$TiO_2$-Partikeln wird mit Hilfe des OVD-Verfahrens ein Sootkörper hergestellt, der mit ca. 8 Gew.-% $TiO_2$ dotiert ist.

Im Unterschied zu den oben erläuterten Verfahrensweisen wird hierbei während des gesamten Abscheideprozesses die Oberflächen-Temperatur des Sootkörpers geringfügig variiert. Dieser kleine Unterschied führt zu einer anderen Verteilung der $TiO_2$-Konzentration.

Beispiel 4

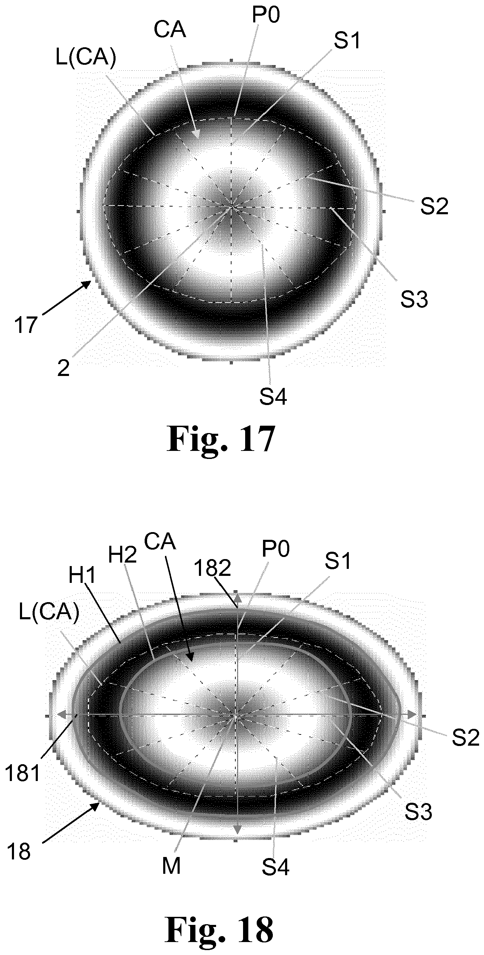

Die Ausgangsplatte aus $TiO_2$-$SiO_2$-Glas mit einem Durchmesser von 200 mm und einer Dicke von 195 mm wird in einem Ofen durch laterale Umformung zu einer ovalen Platte 18 umgeformt, wie schematisch in **Figur 18** gezeigt. Hierzu wird die Ausgangsplatte mittig in eine Schmelzform aus Grafit eingelegt, die einen ovalen Innenquerschnitt aufweist, ähnlich wie dies für Beispiel 1 bereits erläutert worden ist. Die laterale Verformung durch Erweichen und Ausfließenlassen in die Schmelzform erfolgt wie anhand Beispiel 1 erläutert. Der Streckfaktor in Richtung der langen Oval-Halbachse 181 im Vergleich zur in **Figur 17** schematisch dargestelltem Rundplatte 17 aus derselben Ausgangsplatte beträgt etwa 1,5; der in Richtung der kurzen Achse 182 ist praktisch gleich 1.

Die so erhaltene ovale Platte 9 besteht aus homogenisiertem, hochkieselsäurehaltigem Glas, das 8 Gew.-% Titanoxid und einen mittleren Hydroxylgruppengehalt um 170 Gew.-ppm enthält.

Die Falschfarbendarstellung in Fig. 18 (als Grauschattierung mit der Graustufenskala von Fig. 1) zeigt in etwa eine Spiegelsymmetrie bezüglich der Hauptachsen 181 und 182 des Ovals. Die dCTE-Extremwerte (5 ppb/K) und (0 ppb/K) sind die gleichen wie bei der ursprünglichen Ausgangsplatte und bei den vorher beschriebenen Beispielen 1 bis 3. Zwischen den dCTE-Verteilungsprofilen der Ausgangsplatte und der Platte 18 mit ovalem Querschnitt besteht "Ähnlichkeit" in dem Sinn, dass die wesentlichen Merkmale des dCTE-Verteilungsprofils in der ovalen Form, nämlich die Anzahl der relativen und absoluten Extremwerte der Verteilung als auch deren relative Lage zueinander gleich sind. Insoweit erfüllt das dCTE-Verteilungsprofil von Fig. 18 bereits einen Teil der oben erläuterten Grundbedingungen, die dem Konstruktionsprinzip für einen Spiegelsubstrat-Rohling gemäß dieser Erfindung zugrunde liegen. Es ist nicht rotationssymmetrisch, aber durch "geometrische Transformation" - unter Berücksichtigung einfacher Streckverformungen - ist es in die ursprünglich rotationssymmetrische Verteilung der runden Ausgangsplatte mathematisch eindeutig überführbar.

Im Vergleich zu diesem rotationssymmetrischen Verteilungsprofil (das auch die Rundplatte 17 von Fig. 17 zeigt) zeigt das dCTE-Verteilungsprofil von Fig. 18 darüber hinaus im Zusammenspiel mit einer nicht kreisrunden optisch benutzten Fläche CA eine Interaktion mit vergleichsweise geringer Beeinträchtigung der Abbildungsqualität des Spiegels. Dies wird im Folgenden näher erläutert:

(a) Bandbreite von Schnittlinien

In Fig. 17 ist schematisch die Umrisslinie L(CA) einer optisch genutzten Fläche CA eingezeichnet, die ebenfalls als elliptisch bezeichnet werden kann. Innerhalb von CA sind mehrere durch den Mittelpunkt 2 verlaufende Schnittlinien eingetragen, wovon die besonders charakteristischen Schnittlinien mit den Bezugsziffern S1 bis S4 bezeichnet sind. Der Mittelpunkt 2 bildet gleichzeitig den Flächenschwerpunkt von CA.

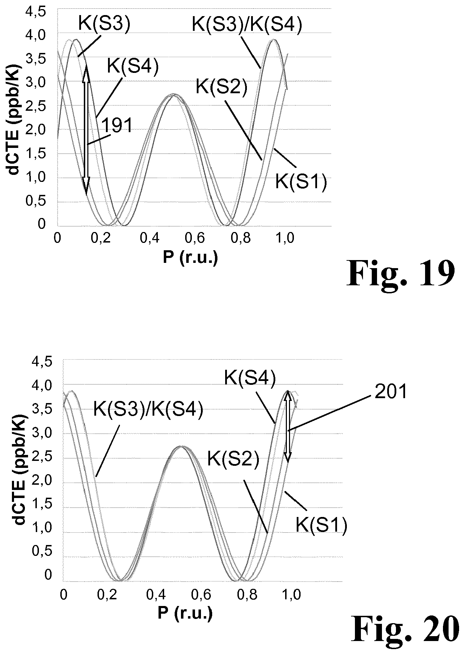

Das Diagramm von **Figur 19** zeigt die dCTE-Verteilungsprofile entlang eine repräsentativen Auswahl dieser Schnittlinien S1 bis S4 (innerhalb von CA). Auf der Ordinate des Diagramms ist der betreffende dCTE-Wert (in ppb(K) aufgetragen und auf der Abszisse ein auf die jeweilige Schnittlinienlänge normierter Positionswert P (in relativen Einheiten), der somit den Bereich von 0 bis 1 abdeckt. Die maximale Inhomogenität $dCTE_{max}$ innerhalb von CA beträgt 3,8 ppb/K. Zwischen den Schnittprofilen K(S1) und K(S3)/K(S4) zeigen sich deutlich unterschiedliche dCTE-Werte im Bereich der Randpositionen 0 und 1. Im Maximum (markiert mit Blockpfeil 191) liegt die Differenz bei etwa 2,8 ppb/K. Das Maximum 191 repräsentiert die maximale Bandbreite der von den Kurven K(S1) bis K(S4) gebildeten Kurvenschar; es beträgt etwa 74 % von $dCTE_{max}$.

Auch im Verteilungsprofil von Fig. 18 ist schematisch die Umrisslinie L(CA) der optisch genutzten Fläche CA mit elliptischer Form eingezeichnet. Der Flächenschwerpunkt von CA liegt im Punkt M. Das Diagramm von **Figur 20** zeigt die dCTE-Verteilungsprofile entlang der Schnittlinien S1 bis S4 (innerhalb von CA) beim dCTE-Verteilungsprofil von Fig. 18. Auch hier ist auf der Ordinate des Diagramms der betreffende dCTE-Wert (in ppb/K) aufgetragen und auf der Abszisse der auf die jeweilige Schnittlinienlänge normierte Positionswert P (in relativen Einheiten). Daraus ist ersichtlich, dass alle Schnittprofile K(S1) bis K(S4) relativ ähnlich sind und ein schmales Kurvenband bilden. Der maximale Unterschied der dCTE-Werte (markiert mit Blockpfeil 201) beträgt etwa 1,3 ppb/K, dCTEmax beträgt 3,8 ppb/K. Die maximale Bandbreite der von den Kurven K(S1) bis K(S4) gebildeten Kurvenschar (Maximum 201) liegt hier demnach bei etwa 34 % von $dCTE_{max}$.

Die Unterschiede in den Breiten der Kurvenscharbänder von Fig. 19 und Fig. 20 sind in diesem Fall nicht so markant als bei den vorherigen Beispielen 1 bis 3. Auch die Amplituden zwischen dCTE-Maximalwert (etwa 3,8 ppb/K) und Minimalwert (0) sind nahezu gleich. Es ist aber dennoch erkennbar, dass die Profilschnitte K(S1) bis K(S4) beim dCTE-Verteilungsprofil von Fig. 20 innerhalb von CA eine höhere Ähnlichkeit haben als beim Profil von Fig. 19. Die höhere Ähnlichkeit der Profilschnitte bewirkt eine gleichmäßigere Verzerrung des erfindungsgemäßen Spiegelsubstrat-Rohlings beim Erwärmen und damit einer einfachere Korrektur der dadurch entstehenden Abbildungsfehler.

(b) Verlauf der Isolinie mit dem Niveau 0,5 x $dCTE_{max}$,

Das dCTE-Verteilungsprofil von Fig. 18 hat zwei Isolinien auf dem Niveau 0,5 x $dCTE_{max}$; eine weiter innen verlaufende Isolinie H2 und eine die innere Isolinie vollständig umgebende, äußere Isolinie H2. Bei derartigen Profilen ist diejenige Isolinie für die Güte der Anpassung an die nicht-rotationssymmetrische CA maßgeblich, die am nächsten an der Umrisslinie von CA verläuft. Beim Profil von Fig. 18 ist dies die innere Isolinie H2. In anderen Fällen, bei denen nicht eindeutig feststellbar ist, welche Isolinie mit dem Niveau 0,5 x $dCTE_{max}$ näher an CA verläuft oder bei denen es eine solche Isolinie nicht gibt, ist dieses Kriterium zur Einstellung und Beurteilung der Anpassungsgüte des dCTE-Verteilungsprofils an CA nicht anwendbar.

Im Fall des Verteilungsprofils von Fig. 18 ist erkennbar, dass die innere Isolinie H1 mit ihrer gesamten Isolinienlänge innerhalb der Umrisslinie L(CA) der optisch genutzten Fläche CA verläuft. Das bedeutet, dass auch die Form des dCTE-Inhomogenitäts-Profils beim Spiegelsubstrat-Rohling 19 von Fig. 18 der Umrisslinie L(CA) insoweit angepasst ist, dass die CA-Umrisslinie L(CA) von möglichst wenigen Isolinien des Verteilungsprofils geschnitten wird.

Damit erfüllt auch Rohling 19 in Verbindung mit seiner spezifischen, optisch genutzten Fläche CA alle Bedingungen des allgemeinen Konstruktionsprinzips gemäß der Erfindung, nämlich die Anforderung an das dCTE-Verteilungsprofil des Rohlings und das Zusammenspiel zwischen dem dCTE-Verteilungsprofil und der optisch beanspruchten Fläche CA mit nicht-kreisrunder Umrisslinie L(CA).

Zur Herstellung eines Spiegelsubstrats wird die Oberseite des Spiegelsubstrat-Rohlings einer mechanischen Bearbeitung unterzogen, die Schleifen und Polieren umfasst. Dabei wird beispielsweise ein konvex gekrümmter Oberflächenbereich erzeugt, von dem beispielsweise eine pentagonale Teilfläche - wie in Fig. 4 gezeigt - als hochbelasteter Oberflächenbereich CA mit besonders hohen Anforderungen an die Qualität der Oberfläche und an die Homogenität des Quarzglases spezifiziert ist. Die gekrümmte Oberfläche des Spiegelsubstrats wird mit einer Spiegelschicht versehen und das erhaltene Spiegelelement wird in einem Projektionssystem für die EUV-Lithographie eingesetzt.

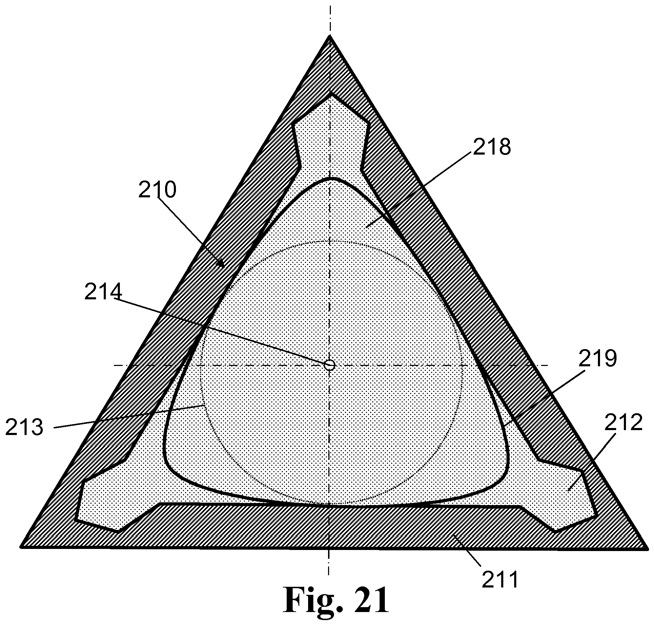

Bei allen Beispielen wurde der Spiegelsubstrat-Rohling gemäß der Erfindung durch laterale Verformung (Streckung) einer Rundplatte erzeugt. Anhand **Figur 21** wird diese Verfahrensweise für einen Spiegelsubstrat-Rohling 210 mit Dreiecksform näher erläutert. Das im Rohling 210 erzeugte dCTE-Verteilungsprofil 100 hat eine dreizählige Symmetrie, wobei die Ecken des Dreiecks herstellungsbedingt aufgeweitet sind und nachträglich entfernt werden.

Zur Herstellung des Rohlings 210 wird eine Grafitform 211 eingesetzt, deren Innengeometrie dreiecksförmig ist, jedoch mit Ausbuchtungen 212 an den Dreieckspitzen. Eine Rundplatte (angedeutet mit dem punktierten Kreis 213) wird so in die Grafitform eingelegt, dass die Mittelachse 214 von Rundplatte 213 und Grafitform 211 konzentrisch verlaufen. Bei einer nicht-konzentrisch Anordnung - die alternativ zur Herstellung eines Spiegelsubstrat-Rohlings geeignet wäre- ergäbe sich eine Abweichung von der hier gewünschten dreizähligen Symmetrie des dCTE-Verteilungsprofils.

Durch Erhitzen, Erweichen und Ausfließenlassen der Rundplatte 213 (wie oben anhand des Beispiels von Fig. 4 erläutert), wird die Innengeometrie der Grafitform 211 ausgefüllt. Infolge der Ausbuchtungen 212 der Grafitform 211 ergeben sich an den Ecken des Spiegelsubstrat-Rohlings 210 Fließvorgänge, die zu einer stärkeren Ausprägung der Ecken des resultierenden dCTE-Verteilungsprofils führen, wie dies die Konturlinie 219 anzeigt. In der Draufsicht auf die optisch genutzte Fläche umreißt die Konturlinie 219 die Form eines Wankelmotorkolbens oder eines Plektrons. Die Konturlinie 219 symbolisiert dabei lediglich die Form des dCTE-Verteilungsprofils (wie etwa definiert durch einen dCTE-Isolinienwert, der noch innerhalb von CA liegt. Das dCTE-Verteilungsprofil setzt sich auch außerhalb dieser Konturlinie 219 nach außen fort.

Allgemeine Betrachtung für einen Sonderfall von CA

Anhand der Figuren 9 und 14 wurden Sonderfälle eines erfindungsgemäßen Spiegelsubstrat-Rohlings erläutert, bei denen die optisch genutzte Fläche CA im Wesentlichen durch zwei senkrecht aufeinander stehende Achsen a, b mit unterschiedlichen Längen definiert ist (a>b). Bei derartigen Spezialfällen kann der CTE-Inhomogenitätsverlauf $dCTE_a$ beziehungsweise $dCTE_b$ in Richtung dieser beiden Achsen in Anlehnung an die eingangs genannte DE 10 2004 024 808 A1 durch folgende Formeln (2) und (3) allgemein beschrieben werden:

$$dCTE_a \quad = \quad C_0 + C_1 (x/a) + C_2 (2 (x/a)^2 - 1) + C_3 (6 (x/a)^4 - 6 (x/a)^2 + 1) \quad (2)$$

$$dCTE_b \quad = \quad C_0 + C_2 (2 (y/b)^2 - 1) + C_3 (6 (y/b)^4 - 6 (y/b)^2 + 1) \quad (3)$$

wobei nach Abzug von $dCTE_a$ von der real vorhandenen CTE-Inhomogenitäts-Verteilung über CA eine minimale Restinhomogenität von nicht mehr als 0,5 ppb/K übrig bleibt. Die Parameter in den Formeln (2) und (3) bedeuten dabei:

a = lange Achse, b= kurze Halbachse und
x= Abstand entlang der Achse a,
y= Abstand entlang der Achse b,
$C_0$, $C_1$, C2, $C_3$ = Anpassungsparameter der sphärischen Zernike-Terme.

Diese allgemeine Beschreibung nicht-rotationssymmetrischer Verteilungsprofile ersetzt jedoch nicht die oben erläuterten zusätzlichen Erfordernisse hinsichtlich der Ähnlichkeit von Profilschnitten durch den Massenschwerpunkt der jeweiligen optisch genutzten, nicht runden CA.

## Patentansprüche

1. Rohling aus Titan-dotiertem Kieselglas für ein Spiegelsubstrat für den Einsatz in der EUV-Lithographie, mit einem zu verspiegelnden Oberflächenbereich mit einer optisch genutzten Fläche CA, über der der thermische Ausdehnungskoeffizient CTE ein über die Rohling-Dicke gemitteltes, zweidimensionales dCTE-Verteilungsprofil mit einer als Differenz zwischen einem CTE-Maximalwert (51, 61, 101, 111, 151, 161, 191, 201) und einem CTE-Minimalwert definierten, maximalen Inhomogenität $dCTE_{max}$ von weniger als 5 ppb/K aufweist, **dadurch gekennzeichnet, dass** $dCTE_{max}$ mindestens 0,5 ppb/K beträgt, und dass CA eine nicht-kreisrunde Fläche mit einem Flächenschwerpunkt (2; M) bildet, wobei das dCTE-Verteilungsprofil nicht rotationssymmetrisch und über CA derart definiert ist, dass gerade und auf eine Einheitslänge normierte Profilschnitte (S1, S2, S3, S4, S5, S6) durch den Flächenschwerpunkt (2; M) eine dCTE-Kurvenschar (K(S1), K(S2), K(S3), K(S4), K(S5), K(S6)) ergeben, die ein Kurvenband mit einer Bandbreite von weniger als 0,5 x $dCTE_{max}$ bilden.

2. Rohling nach Anspruch 1, **dadurch gekennzeichnet, dass** die Bandbreite weniger als 0,3 x $dCTE_{max}$ beträgt.

3. Rohling nach Anspruch 1 oder 2, **dadurch gekennzeichnet, dass** das dCTE-Verteilungsprofil eine geschlossene Isolinie (H1, H2, H3) mit einem dCTE-Wert von 0,5 x $dCTE_{max}$, von der eine Teillänge von mindestens 80% der Isolinien-Gesamtlänge innerhalb der optisch genutzten Fläche CA verläuft, umfasst.

4. Rohling nach Anspruch 3, **dadurch gekennzeichnet, dass** die Isolinie H1, H2, H3) vollständig innerhalb von CA verläuft.

5. Rohling nach Anspruch 1 oder 2, **dadurch gekennzeichnet, dass** die nicht kreisrunde Fläche von CA durch eine nicht-kreisrunde Umrisslinie (L(CA)) definiert ist, entlang der ein dCTE-Höchstwert und ein dCTE-Niedrigstwert des dCTE-Verteilungsprofils liegen, wobei der Differenzbetrag - $PV_{CA}$ - zwischen Höchst- und Niedrigstwert maximal 0,5 x $dCTE_{max}$ beträgt

6. Rohling nach Anspruch 5, **dadurch gekennzeichnet, dass** der Differenzbetrag $PV_{CA}$ maximal 0,3 x $dCTE_{max}$ beträgt.

7. Rohling nach einem der vorhergehenden Ansprüche, **dadurch gekennzeichnet, dass** das dCTE-Verteilungsprofil durch Strecken eines rotationssymmetrischen Verteilungsprofils in mindestens einer Raumrichtung mathematisch eineindeutig beschreibbar ist, wobei der Streckfaktor mindestens 1,2 beträgt.

8. Rohling nach einem der vorhergehenden Ansprüche, **dadurch gekennzeichnet, dass** das Verteilungsprofil durch Strecken einer Rundform in mehreren Raumrichtungen mathematisch eineindeutig beschreibbar ist, wobei diese Raumrichtungen in einer gemeinsamen Verformungsebene verlaufen, die sich parallel zur optisch genutzten Fläche CA erstreckt.

**9.** Rohling nach Anspruch 8, **dadurch gekennzeichnet, dass** das dCTE-Verteilungsprofil durch Strecken der Rundform in drei in derselben Verformungsebene verlaufenden Richtungen, die einen Winkel von 120 Grad einschließen, beschreibbar ist.

**10.** Verfahren zur Herstellung eines Rohlings aus Titan-dotiertem Kieselglas für ein Spiegelsubstrat für den Einsatz in der EUV-Lithographie nach einem der vorhergehenden Ansprüche, umfassend die folgenden Verfahrensschritte:

(a) Bereitstellen eines Glaszylinders (213) aus Ti-dotiertem Kieselglas mit rotationssymmetrischem dCTE-Verteilungsprofil, umfassend:

(aa) Erzeugen eines porösen Sootkörpers aus $SiO_2$ und $TiO_2$ durch Flammenhydrolyse von Silizium und Titan enthaltenden Ausgangssubstanzen,
(bb) Trocknen und Sintern des Sootkörpers unter Bildung eines länglichen Glasvorprodukts aus Ti-dotiertem Kieselglas,
(cc) Homogenisieren des Glasvorprodukts in einem Homogenisierungsprozess, bei dem das Vorprodukt auf eine Temperatur von mehr als 1.500 °C erhitzt, dabei erweicht und zu dem Glaszylinder umgeformt wird, und

(b) Umformen des Glaszylinders (213), indem dieser erweicht und unter Einwirkung einer Umformkraft, die eine senkrecht zur Glaszylinder-Längsachse (214) wirkende Kraftkomponente hat infolge geometrischer Transformation in eine senkrecht zur Glaszylinder-Längsachse (214) verlaufenden Richtung zu einem zylinderförmigen Rohling (210) geformt wird, der einen nicht-kreisrunden Querschnitt und ein nicht- rotationssymmetrisches dCTE-Verteilungsprofil hat.

**11.** Verfahren nach Anspruch 10, **dadurch gekennzeichnet, dass** das Umformen gemäß Verfahrensschritt (b) einen Umformschritt umfasst, bei dem der Glaszylinder (213) mit vertikal orientierter Glaszylinder-Längsachse (214) in einer Schmelzform (211) mit nicht-rotationssymmetrischer Innengeometrie angeordnet und darin auf eine Temperatur von mindestens 1.200 °C erhitzt und dabei so erweicht wird, dass er unter Einwirkung der Schwerkraft, vorzugsweise unterstützt durch eine Presskraft, in die Schmelzform (211) seitlich ausfließt.

**12.** Verfahren nach Anspruch 11, **dadurch gekennzeichnet, dass** eine Schmelzform (211) eingesetzt wird, deren Innengeometrie im Querschnitt in Richtung senkrecht zur Glaszylinder-Längsachse gesehen eine lange Achse und eine demgegenüber kürzere Achse aufweist.

**13.** Verfahren nach Anspruch 12, **dadurch gekennzeichnet, dass** eine Schmelzform mit einer im Querschnitt ovalen Innengeometrie oder mit einer im Querschnitt rechteckigen Innengeometrie eingesetzt wird.

**14.** Verfahren nach einem der Ansprüche 10 bis 13, **dadurch gekennzeichnet, dass** das Umformen gemäß Verfahrensschritt (b) mehrere Umformschritte umfasst, wobei der nach einem Umformschritt erhaltene Glaskörper in einem nachfolgenden Umformschritt weiter verformt wird.

**Claims**

**1.** A blank made of titanium-doped silica glass for a mirror substrate for use in EUV lithography, with a surface portion to be provided with a reflective film and having an optically used area CA over which the coefficient of thermal expansion CTE has a two-dimensional dCTE distribution profile averaged over the thickness of the blank with a maximum inhomogeneity $dCTE_{max}$ of less than 5 ppb/K defined as a difference between a CTE maximum value (51, 61, 101, 111, 151, 161, 191, 201) and a CTE minimum value, **characterized in that** $dCTE_{max}$ is at least 0.5 ppb/K, and that CA forms a non-circular area with a centroid (2; M) of the area, wherein the dCTE distribution profile is not rotation-symmetrical and is defined over CA such that straight profile sections (S1, S2, S3, S4, S5, S6) normalized to a unit length and extending through the centroid (2; M) of the area yield a dCTE family of curves (K(S1), K(S2), K(S3), K(S4), K(S5), K(S6)) forming a curve band with a bandwidth of less than 0.5 x $dCTE_{max}$.

2. The blank according to claim 1, **characterized in that** the bandwidth is less than 0.3 x $dCTE_{max}$.

3. The blank according to claim 1 or 2, **characterized in that** the dCTE distribution profile comprises a closed isoline (H1, H2, H3) with a dCTE value of 0.5 $dCTE_{max}$, of which a sub-length of at least 80% of the total length of the isoline extends within the optically used area CA.

4. The blank according to claim 3, **characterized in that** the isoline (H1, H2, H3) fully extends within CA.

5. The blank according to claim 1 or 2, **characterized in that** the non-circular area of CA is defined by a non-circular outline (L(CA)) along which a dCTE maximum value and a dCTE minimum value of the dCTE distribution profile are positioned, wherein the difference - $PV_{CA}$ - between maximum value and minimum value is not more than 0.5 x $dCTE_{max}$.

6. The blank according to claim 5, **characterized in that** the difference $PV_{CA}$ is not more than 0.3 x $dCTE_{max}$.

7. The blank according to any one of the preceding claims, **characterized in that** the dCTE distribution profile is mathematically described in a biunique manner by stretching a rotation-symmetrical distribution profile in at least one spatial direction, wherein the stretching factor is at least 1.2.

8. The blank according to any one of the preceding claims, **characterized in that** the dCTE distribution profile is mathematically described in a biunique manner by stretching a round form in plural spatial directions, wherein said spatial directions extend in a common deformation plane extending in parallel with the optically used area CA.

9. The blank according to claim 8, **characterized in that** the dCTE distribution profile is described by stretching the round form in three directions extending in the same deformation plane and enclosing an angle of 120 degrees.

10. A method for producing a blank from titanium-doped silica glass for a mirror substrate for use in EUV lithography according to one of the preceding claims, the method comprising the following steps:

    (a) providing a glass cylinder (213) of Ti-doped silica glass with rotation-symmetrical dCTE distribution profile, comprising

    (aa) producing a porous soot body of $SiO_2$ and $TiO_2$ by flame hydrolysis of start substances containing silicon and titanium,
    (bb) drying and sintering the soot body to form an elongated glass pre-product of Ti-doped silica glass,
    (cc) homogenizing the glass pre-product in a homogenization process in which the pre-product is heated to a temperature of more than 1,500°C, is softened therein and shaped into the glass cylinder, and

    (b) shaping the glass cylinder (213) by softening said cylinder and forming the same under the action of a shaping force having a force component acting in a direction perpendicular to the longitudinal axis (214) of the glass cylinder, as a result of geometric transformation in a direction perpendicular to the longitudinal axis (214) of the glass cylinder, thereby stretching the rotation-symmetrical profile in at least one direction so as to obtain a cylindrical blank (210) which has a non-circular cross-section and a non-rotation symmetrical dCTE distribution profile.

11. The method according to claim 10, **characterized in that** the shaping according to method step (b) comprises a shaping step in which the glass cylinder (213) with vertically oriented longitudinal axis (214) of the glass cylinder is arranged in a melt mold (211) with non-rotation symmetrical inner geometry and is heated therein to a temperature of at least 1,200°C and is softened thereby such that it flows out laterally into the melt mold (211) under the action of gravity, preferably supported by a pressing force.

12. The method according to claim 11, **characterized in that** a melt mold (211) is used having an inner geometry which viewed in cross section in a direction perpendicular to the longitudinal axis of the glass cylinder has a long axis and a shorter axis in comparison therewith.

13. The method according to claim 12, **characterized in that** a melt mold is used with an inner geometry which is oval in cross section or with an inner geometry which is rectangular in cross section.

**14.** The method according to any one of claims 10 to 13, **characterized in that** the shaping according to method step b) comprises a plurality of shaping steps, wherein the glass body obtained after a shaping step is further deformed in a subsequent shaping step.

**Revendications**

**1.** Ébauche en verre de quartz dopé au titane pour un substrat de miroir, destinée à une utilisation dans la lithographie EUV, avec une zone superficielle à appliquer une couche réfléchissante avec une surface CA utilisée à des fins optiques, sur laquelle le coefficient de dilatation thermique CTE présente un profil de distribution dCTE bidimensionnel déterminé par le biais de la moyenne de l'épaisseur de l'ébauche avec un manque d'homogénéité maximum dCTEmax de moins de 5 ppb/K défini comme la différence entre une valeur maximum CTE (51, 61, 101, 111, 151, 161, 191, 201) et une valeur minimum CTE, **caractérisée en ce que** dCTEmax est d'au moins 0,5 ppb/K, et **en ce que** la surface CA forme une surface non-circulaire avec un barycentre surfacique (2 ; M), le profil de distribution dCTE étant défini sans symétrie de révolution et via la surface CA de telle manière que des sections de profil rectilignes et normalisées sur une longueur unitaire (S1, S2, S3, S4, S5, S6) résultent, par le barycentre surfacique (2 ; M), en un ensemble de courbes dCTE (K(S1), K(S2), K(S3), K(S4), K(S5), K(S6)), qui forment une trajectoire courbe avec une bande passante de moins de 0,5 x dCTEmax.

**2.** Ébauche selon la revendication 1, **caractérisée en ce que** la largeur de bande est inférieure à 0,3 x dCTEmax.

**3.** Ébauche selon la revendication 1 ou 2, **caractérisée en ce que** le profil de distribution dCTE comprend une isoligne fermée (H1, H2, H3) avec une valeur dCTE de 0,5 x dCTEmax, dont une longueur partielle d'au moins 80 % de la longueur totale de l'isoligne s'étire à l'intérieur de la surface CA utilisée à des fins optiques.

**4.** Ébauche selon la revendication 3, **caractérisée en ce que** l'isoligne (H1, H2, H3) s'étend en intégralité à l'intérieur de la surface CA.

**5.** Ébauche selon la revendication 1 ou 2, **caractérisée en ce que** la surface non-circulaire de la surface CA est définie par une ligne de contour non-circulaire (L(CA)), le long de laquelle se situent une valeur maximum dCTE et une valeur minimum dCTE du profil de distribution dCTE, la différence - PVCA - entre la valeur maximum et la valeur minimum étant de 0,5 x dCTEmax, au maximum.

**6.** Ébauche selon la revendication 5, **caractérisée en ce que** la différence PVCA est au plus de 0,3 x dCTEmax.

**7.** Ébauche selon l'une quelconque des revendications précédentes, **caractérisée en ce que** le profil de distribution dCTE peut être expliqué clairement d'un point de vue mathématique par l'allongement d'un profil de distribution avec symétrie de révolution dans au moins une direction spatiale, le facteur d'allongement étant au moins 1,2.

**8.** Ébauche selon l'une quelconque des revendications précédentes, **caractérisée en ce que** le profil de distribution peut être expliqué clairement d'un point de vue mathématique par l'allongement d'une forme ronde dans plusieurs directions spatiales, dans lequel ces directions spatiales s'étirent dans un niveau de déformation commun qui s'étend parallèlement à la surface CA utilisée à des fins optiques.

**9.** Ébauche selon la revendication 8, **caractérisée en ce que** le profil de distribution dCTE peut être expliqué par l'allongement de la forme ronde dans trois directions s'étirant dans le même niveau de déformation, qui englobent un angle de 120 degrés.

**10.** Procédé de fabrication d'une ébauche en verre de quartz dopé au titane pour un substrat de miroir destinée à une utilisation dans la lithographie EUV selon l'une quelconque des revendications précédentes, comprenant les étapes de procédé suivantes :

(a) la mise à disposition d'un cylindre en verre (213) fabriqué à partir de verre de quartz dopé au titane avec un profil de distribution dCTE avec symétrie de révolution, comprenant les étapes de procédé suivantes :

(aa) la création d'un corps de suie poreux en SiO2 et TiO2 par le biais d'une hydrolyse à la flamme de substances mères contenant silicium et titane,
(bb) le séchage et le frittage du corps de suie avec formation d'un produit en verre intermédiaire oblong fabriqué à partir de verre de quartz dopé au titane,

(cc) l'homogénéisation du produit en verre intermédiaire dans le cadre d'un processus d'homogénéisation dans lequel le produit intermédiaire est chauffé à une température supérieure à 1500 °C, ramolli et transformé en cylindre en verre, et

(b) le modelage du cylindre en verre (213), processus au cours duquel celui-ci est ramolli puis, sous l'action d'une force de modelage qui comporte une composante de force agissant perpendiculairement à l'axe longitudinal du cylindre en verre (214) suite à une transformation géométrique dans une direction s'étirant perpendiculairement à l'axe longitudinal du cylindre en verre (214), transformé en une ébauche de forme cylindrique (210) qui présente une section transversale non-circulaire et un profil de distribution dCTE sans symétrie de révolution.

11. Procédé selon la revendication 10, **caractérisé en ce que** le modelage, conformément à l'étape de procédé (b), comprend une étape de modelage lors de laquelle le cylindre en verre (213) avec un axe longitudinal du cylindre en verre à orientation verticale (214) est placé dans un moule de fusion (211) avec une géométrie intérieure sans symétrie de révolution et chauffé à l'intérieur à une température d'au moins 1200 °C puis ramolli durant ce processus de sorte à s'écouler latéralement sous l'action de la gravité, de préférence avec l'assistance d'une force de pression, dans le moule de fusion (211).

12. Procédé selon la revendication 11, **caractérisé en ce qu'**un moule de fusion (211) est utilisé dont la géométrie intérieure comporte dans la section transversale perpendiculairement à l'axe longitudinal du cylindre en verre, un axe longue et un axe comparativement plus court.

13. Procédé selon la revendication 12, **caractérisé en ce qu'**un moule de fusion est utilisé avec, une géométrie intérieure ovale dans la section transversale ou avec, toujours dans la section transversale, une géométrie intérieure rectangulaire.

14. Procédé selon l'une quelconque des revendications 10 à 13, **caractérisé en ce que** le modelage, conformément à l'étape de procédé (b), comprend plusieurs étapes de modelage, étant entendu que le corps en verre obtenu après une étape de modelage est encore transformé au cours d'une étape de modelage suivante.

**Fig. 1**

**Fig. 2**

**Fig. 3**

**Fig. 4**

Fig. 5

Fig. 6

Fig. 7

**Fig. 8**

**Fig. 9**

Fig. 10

Fig. 11

Fig. 12

**Fig. 13**

**Fig. 14**

**Fig. 15**

**Fig. 16**

Fig. 17

Fig. 18

Fig. 19

Fig. 20

**Fig. 21**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2011078414 A2
- DE 102004024808 A1
- US 20100003609 A1
- EP 673888 A1